# FASCICULE DE BREVET EUROPEEN

(11) **EP 0 566 494 B1**
(45) Date de publication et mention de la délivrance du brevet: **02.04.1997**
(21) Numéro de dépôt: 93400986.1
(22) Date de dépôt: 15.04.1993
(51) Int. Cl.: H01S 3/18, H01S 3/0959, H01S 3/091, H01S 3/043, H01L 33/00

(54) **Cavité laser à hétérostructure semi-conductrice dissymétrique à pompage électronique**
Elektronenstrahl gepumpter Laserresonator mit asymmetrischer Halbleiter-Heterostruktur
Electron beam pumped asymmetric laser cavity with semiconductor heterostructure

(30) Priorité: 17.04.1992 FR 9204791
(43) Date de publication de la demande: 20.10.1993
(73) Titulaire: COMMISSARIAT A L'ENERGIE ATOMIQUE, 75015 Paris (FR)
(72) Inventeur: Molva, Engin, F-38000 Grenoble (FR); Accomo, Roger, F-38420 Le Versoud (FR); Feuillet, Guy, F-38410 Saint Martin d'Uriage (FR); Cibert,Joel, F-38330 St Nazaire les Eymes (FR); Le Si, Dang, F-38330 Montbonnot St Martin (FR); Bodin-Deshayes, Claire, F-38100 Grenoble (FR)
(74) Mandataire: Dubois-Chabert, Guy

(56) Documents cités:
- EP-A- 0 454 566
- SOVIET JOURNAL OF QUANTUM ELECTRONICS vol. 8, no. 6, Juin 1978, NEW YORK US pages 747 - 751 O.V BOGDANKEVICH ET AL 'Variable gap structures in electron beam pumped semiconductor lasers'
- SOVIET JOURNAL OF QUANTUM ELECTRONICS vol. 17, no. 9, Septembre 1987, NEW YORK
- US pages 1155 - 1156 O.V BOGDANKEVICH ET AL 'AlxGa1-xAs heterostructure for an electron beam pumped laser'
- CONFERENCE RECORD OF THE 1985 INTERNATIONAL DISPLAY RESEARCH CONFERENCE OCTOBER 15-17, 1985 SAN DIEGO CALIFORNIA US pages 200 - 203 R.N. BHARGAVA ET AL 'Visible e-beam pumped lasers from II-VI semiconductors'
- PHILIPS JOURNAL OF RESEARCH vol. 46, no. 4/5, 1992, EINDHOVEN NL pages 137 - 155 H.J CORNELISSEN ET AL 'Blue solid state laser based on electron beam pumped ZnSe/ZnSSe double heterostructures'

## Description

La présente invention a pour objet une cavité laser à hétérostructure semi-conductrice utilisable plus spécialement dans les microlasers.

Ces microlasers peuvent être pompés optiquement ou électroniquement et émettre dans une grande gamme de longueurs d'ondes allant du visible à l'infrarouge. La gamme d'émission est fonction des matériaux utilisés pour l'hétérostructure.

Plus spécialement, la cavité laser est pompée par une source extérieure à la cavité permettant en particulier l'émission d'une lumière laser visible de 0,4 à 0,6µm dont les applications sont nombreuses. En effet, un tel laser peut être utilisé pour l'enregistrement et la lecture optique d'informations, par exemple sur des disques compacts audio et vidéo, des CD-ROM (disques compacts-mémoires à lecture seule), des mémoires WORM (une écriture-plusieurs lectures), des mémoires effaçables (du type magnéto-optique ou à changement de phase) ou dans les imprimantes laser et la reprographie en générale.

Il peut aussi être utilisé dans d'autres applications comme par exemple dans les lecteurs de code barre, l'instrumentation de laboratoire, la spectroscopie, l'instrumentation bio-médicale, les pointeurs, les spectacles, la visualisation par projection, la communication sous-marine, etc.

Pour l'enregistrement et la lecture optique d'informations, la cavité laser de l'invention permet une augmentation de la densité d'enregistrement et une simplification de l'instrumentation optique. Dans les imprimantes laser, la cavité de l'invention permet une meilleure définition de l'image et une augmentation de la vitesse d'impression par rapport aux systèmes connus et une meilleure adaptation des longueurs d'onde aux matériaux photosensibles.

Les différents types de lasers à semi-conducteurs connus sont les diodes laser à injection qui sont les seuls lasers à semi-conducteurs se trouvant actuellement sur le marché, les lasers à cavité laser pompée par une source extérieure optique et les lasers à pompage externe électronique de la cavité laser.

Les lasers pompés par une source externe présentent des avantages par rapport aux diodes laser, résidant notamment dans la séparation des fonctions et éléments de pompage et de la cavité laser.

En effet, dans les diodes laser à injection, ces fonctions de base (pompage, cavité) sont réalisées sur le semi-conducteur par des dopages électriques appropriés de type P et N de différentes couches épitaxiées, et par des prises de contacts électriques (de type ohmique).

Les différentes opérations de fabrication de ces diodes nécessitent une parfaite maîtrise de la technologie d'élaboration des hétérostructures et ne sont actuellement maîtrisées que pour certains semi-conducteurs de la famille des composés III-V (de type GaAlAs). Ceci limite le domaine de longueurs d'onde accessibles à ces diodes laser entre 0,6 et 1,5µm.

Dans les lasers à pompage extérieur, l'injection des porteurs (électrons et trous) qui se recombinent dans la zone active du semi-conducteur pour produire l'émission de lumière, se fait, par définition, par une source extérieure au milieu actif semi-conducteur. Par conséquent, il n'est pas nécessaire de doper de type P ou N les différentes couches épitaxiées de la structure laser. Il n'est pas nécessaire non plus de prendre des contacts électriques sur ces couches.

Ceci simplifie extrêmement la métallurgie du milieu actif semi-conducteur, où seules les caractéristiques de confinement électrique (pompage électronique, puits quantiques), de confinement optique (guidage de la lumière émise) et de longueur d'onde sont à considérer.

Cet avantage permet d'utiliser dans les lasers à pompage extérieur tous les semi-conducteurs à gap direct, et en particulier les alliages II-VI à base de Zn, Cd, Mn, Mg, Hg et de S, Se, Te où les technologies de dopage et de contact ne sont pas ou mal maîtrisées. Or actuellement, on ne sait pas fabriquer de diodes laser en matériau II-VI équivalentes aux diodes laser III-V connues. Ces problèmes sont d'autant plus difficiles que le gap des matériaux est grand et que donc la longueur d'onde d'émission est courte. Les lasers à pompage extérieur dans leur conception font disparaître ces problèmes technologiques.

La possibilité d'utiliser tous les semi-conducteurs à gap direct pour les lasers à pompage extérieur, rend ainsi accessible le domaine des longueurs d'onde entre le bleu et l'infrarouge moyen. En particulier, les lasers émettant dans le bleu-vert permettent de satisfaire aux besoins actuels pour toutes les applications concernant l'enregistrement optique. Ce domaine n'est pas actuellement couvert par les diodes laser à injection.

Des études sont actuellement en cours pour réaliser des diodes laser émettant dans le bleu-vert, soit à partir des semi-conducteurs II-VI avec les difficultés citées ci-dessus, soit à partir de diodes laser III-V émettant dans l'infrarouge par doublage de fréquence ou par des effets non linéaires similaires.

Indépendamment du mode de pompage utilisé, trois types de structures sont couramment utilisés comme milieu actif semi-conducteur. Ces structures peuvent consister en un matériau semi-conducteur massif, en des matériaux semi-conducteurs en couches minces, ou en une hétérostructure.

Les performances des lasers à hétérostructure sont nettement supérieures à celles des lasers à semi-conducteurs en matériau massif ou en couches minces.

Les hétérostructures sont largement utilisées dans les diodes laser en matériau III-V notamment sous forme d'une structure de type GRINSCH (graded-index separate-confinement hétérostructure en terminologie anglo-saxonne) comportant un guide optique à gradient d'indice et un confinement séparé des porteurs (trous et électrons) et de la lumière.

Une structure de diode laser du type GRINSCH est notamment décrite dans les documents W.T. Tsang, Appl. Phys. Lett., 39(2) de juillet 1981, "A graded-index waveguide separate-confinement laser with very low threshold and a narrow Gaussian beam", p. 134-136.

Cette structure de diode laser connue comporte une zone active constituée d'un puits quantique situé au centre d'une structure à gradients de composition, symétrique. Ce puits quantique est en fait une fine couche d'un matériau semi-conducteur de bande d'énergie interdite ou gap inférieur à celui des matériaux adjacents.

Ce gradient de composition induit un gradient de gap et d'indice optique. Le gradient de gap améliore l'efficacité de collection des porteurs amenés par le courant d'injection. Le gradient d'indice permet de centrer le mode optique guidé sur la zone active.

Le résultat est un bon "confinement électronique" et un bon "confinement optique" et une superposition optimum de la zone de gain (puits quantique) et du mode optique guidé.

La structure GRINSCH permet d'obtenir un seuil laser très faible, et elle est la structure "classique" utilisée actuellement dans les diodes laser III-V.

Malheureusement, cette structure classique ne peut pas être pompée par une source extérieure du fait que la zone active est beaucoup trop loin de la surface de la structure ; la distance séparant la zone active de la surface est >1µm et typiquement 2 à 3µm. En outre, l'emploi de dopage N et P ne permet que très difficilement la réalisation de structures de diode laser de type GRINSCH en matériaux II-VI.

Un laser compact à hétérostructure de type GRINSCH et à pompage externe électronique est notamment décrit dans le document FR-A-2 661 566 déposé au nom du demandeur et correspondant à EP-A-0 454 566. Ce laser comprend, comme source de pompage exérieur un canon à électrons comportant une source d'électrons à micropointes. Un tel laser à semi-conducteur et à micropointes, noté LSM, présente tous les avantages du pompage externe et de l'emploi d'une hétérostructure cités précédemment. Cependant, ce LSM nécessite, en l'absence d'une hétérostructure adaptée et optimisée, un courant de fonctionnement élevé pour atteindre la densité de courant de seuil laser, et un pompage à forte tension d'accélération. Son coût énergétique peut être relativement élevé, en rendant difficile la réalisation d'un système compact avec une durée de vie longue.

La présente invention a justement pour objet une nouvelle hétérostructure à semi-conducteur pour cavité laser permettant de remédier à ces inconvénients. Cette hétérostructure permet d'améliorer les performances d'un laser équipé de cette hétérostructure et plus spécialement celle d'un laser du type LSM.

De façon plus précise, l'invention a pour objet une cavité laser à hétérostructure semi-conductrice conformément à la revendication 1. Une méthode pour la fabrication d'une telle cavité laser est définie dans la revendication 12. Un laser avec une telle cavité laser est défini dans la revendication 13.

La décroissance et la croissance de la bande d'énergie interdite peut être linéaire, quasi-linéaire ou parabolique.

Cette cavité laser permet une amélioration et une simplification des cavités laser à hétérostructure de type GRINSCH assurant en particulier un abaissement du seuil de fonctionnement d'un laser à pompage extérieur utilisant cette cavité.

Aussi, l'invention a encore pour objet un laser comportant la cavité définie ci-dessus et des moyens de pompage externes. Ces moyens de pompage peuvent être de type optique ou électronique.

Un pompage optique peut être assuré à l'aide d'une lampe, d'un laser ou d'une diode laser, associés à une optique de focalisation de la lumière excitatrice. La longueur d'onde du laser excitateur doit être inférieure à celle de la cavité laser à hétérostructure ; (inversement son énergie doit être supérieure).

Le pompage électronique peut être assuré par un canon à électrons classique tel que celui décrit dans les documents "Electron beam pumped II-VI lasers", S. Colak, L.J. Fitzpatrick, R.N. Bargava, J. of Crystal Growth 72, p. 504(85), et "Laser cathode ray tubes and their applications", A. Nasibon, SPIE, vol. 893, High Power laser diodes and Applications (88), p. 200, ou par un canon à électrons comportant une source d'électrons formée d'un réseau ou d'une matrice de cathodes émissives à micropointes à émission froide d'électrons par effet de champ. Une telle source est notamment décrite dans le document FR-A-2 661 566.

Une optique électronique adaptée permet la focalisation du faisceau d'électrons éventuellement en forme de ruban.

La fonction essentielle de l'hétérostructure est de garantir un fonctionnement laser à faible seuil (<10-20kW/cm²) entre 77-300K, et aussi à faible tension d'accélération des électrons (<10kV) dans le cas d'un pompage électronique. Ceci est obtenu grâce à l'optimisation de l'hétérostructure et du couplage entre les fonctions qu'elle assure. Dans le cas de la focalisation en ruban, un fonctionnement à faible puissance de pompage (<quelques Watts) optique ou électronique doit être obtenu.

Les quatre zones distinctes de l'hétérostructure assurent trois fonctions différentes : confinement des porteurs et gain, confinement des photons, collection des porteurs.

La zone active d'émission de lumière assure la fonction de gain lumineux et de confinement des porteurs électroniques (trous et électrons). Elle est constituée d'un ou plusieurs puits quantiques et éventuellement d'un super-réseau (ou pseudo-alliage) constitué d'une alternance de puits et de barrières quantiques.

On rappelle qu'une barrière quantique est une fine couche d'un matériau semi-conducteur à bande d'énergie interdite supérieure à celle des matériaux adjacents et qu'un puits quantique est une fine couche d'un matériau semi-conducteur à bande d'énergie interdite inférieure à celle des matériaux adjacents.

La composition et l'épaisseur des puits quantiques déterminent la longueur d'onde d'émission laser. La largeur spectrale de la courbe de gain dépend directement des conditions de croissance de ces puits et peut être améliorée par des traitements thermiques (ou recuits) après croissance épitaxiale, à des températures inférieures à 400°C dans le cas des composés II-VI et en particulier allant de 150 à 400°C. Ce traitement thermique assure une interdiffusion des couches semi-conductrices.

La première zone à gradient de gap décroissant et à indice de réflexion croissant de la première face à la seconde face, constitue en principe la zone d'excitation de la cavité laser, de génération des paires d'électrons-trous et de diffusion accélérée des porteurs vers la zone active. Cette première zone assure donc en principe la fonction de collection des porteurs créés par le faisceau de pompage.

Pour un pompage optique, le faisceau excitateur est absorbé sur quelques centaines de nanomètres. La profondeur dépend du coefficient d'absorption du matériau semi-conducteur interagissant avec le faisceau de pompage, coefficient qui varie avec la longueur d'onde du faisceau excitateur et du gap du semi-conducteur.

Pour un pompage électronique, les paires électrons-trous sont créées sur une profondeur Rp±dRp où Rp est la profondeur moyenne de pénétration des électrons excitateurs et dRp l'extension de cette profondeur moyenne. Rp et dRp sont du même ordre de grandeur (de quelques centaines de nanomètres pour des tensions d'accélération des électrons excitateurs inférieures à 10kV) et augmentent avec l'énergie des électrons incidents.

Les paires d'électrons-trous créées sont attirées par la zone active d'émission, du fait du gradient de gap de la première zone.

La première zone, en plus de ce qui précède, assure une partie du confinement des photons et de guidage de la lumière dans la zone active. Ce confinement des photons est dû à l'utilisation de matériaux dont l'indice de réfraction est supérieur à celui du vide d'une part, et à celui de la quatrième zone d'autre part, et varie à l'intérieur des zones 1 et 3 comme décrit précédemment.

La deuxième partie de confinement optique et du guidage de la lumière est assurée par la troisième zone dont l'indice de réfraction est aussi supérieur à celui du vide d'une part et à celui de la quatrième zone d'autre part, et varie à l'intérieur des zones 1 et 3, comme décrit précédemment.

Cette troisième zone peut, dans certains modes de réalisation, jouer en plus le rôle de création et de collection des porteurs. Dans ce cas, la première zone ne joue plus que le rôle de confinement optique.

Cette troisième zone a avantageusement une épaisseur inférieure à celle de la première zone, ce qui provoque la dissymétrie de la cavité laser.

Afin d'assurer le pompage par une source externe, il est nécessaire que la structure GRINSCH soit proche de la surface de l'hétérostructure soumise au faisceau excitateur. Pour ce faire, les première et troisième zones ont une épaisseur au plus égale à 1µm.

L'asymétrie, tout en assurant un bon confinement optique et électronique, assure un centrage du mode optique guidé sur la zone d'émission afin d'obtenir le maximum de couplage entre les photons émis et le mode guidé. A l'inverse, dans une structure à GRINSCH-symétrique près de la surface (avec une couche de surface mince pour le pompage extérieur), ce couplage n'est pas optimum. Il s'ensuit un abaissement du rendement laser et un fonctionnement à courant élevé du laser.

Par ailleurs, l'asymétrie assure un pompage électronique avec de faibles tensions d'accélération.

L'asymétrie assure en outre une optimisation de la collection et du confinement des porteurs créés près de la surface de la cavité, dans la zone active.

L'asymétrie résulte des épaisseurs différentes entre la première et la troisième zones ainsi que de la pente respectivement de la décroissance et de la croissance du gap de la première et la troisième zones qui sont différentes.

La quatrième zone servant aussi de barrière à la lumière, doit présenter un indice de réfraction inférieur ou égal à l'indice minimum de la troisième zone. Cette zone tampon permet d'assurer un saut d'indices suffisant pour assurer le confinement des photons dans la zone active, d'assurer une adaptation du paramètre de mailles cristallines entre le substrat et la troisième zone de confinement, d'améliorer la qualité du matériau semi-conducteur (qualité structurale et impuretés) et d'éloigner le substrat de la zone de confinement et donc des modes guidés.

Cette zone tampon peut être formée d'un seul matériau ou bien de plusieurs couches de composition différente ou encore inclure un super-réseau (ou pseudo-alliage).

Avantageusement, la zone tampon comporte une couche tampon jouant essentiellement le rôle de barrière optique et une couche d'adaptation.

L'hétérostructure de l'invention peut être réalisée en des matériaux présentant ou non des désaccords de maille importants. Dans le cas où de tels désaccords de maille existent, il est généralement préférable de garder l'ensemble de l'hétérostructure en contrainte cohérente, c'est-à-dire avec des épaisseurs inférieures à l'épaisseur critique dans la partie active de la structure constituée des première, deuxième et troisième zones ; la quatrième zone (couche tampon) peut être relaxée par rapport au substrat.

En effet, au-dessous de l'épaisseur critique, le désaccord de maille entre deux matériaux est accomodé par une déformation élastique ; au-dessus de l'épaisseur critique, des défauts (par exemple dislocations, fautes d'empilement, macles, ...) sont créés. Ces défauts peuvent dégrader les performances et diminuer la durée de vie de la cavité laser.

Toujours dans le cas d'une structure contrainte, et pour certains matériaux (par exemple les composés II-VI et III-V), la bande de valence est décomposée en une bande dite de trous lourds et une bande dite de trous légers : la recombinaison radiative entre les électrons et les trous lourds est plus efficace qu'entre les électrons et les trous légers. Une hétérostructure contrainte pourra donc privilégier le peuplement de la bande de trous lourds.

Les matériaux auxquels s'applique l'invention sont tous les semi-conducteurs à gap direct, et en particulier :
- les semi-conducteurs III-V (Ga, Al, In - As, P, N, Sb),
- les semi-conducteurs II-VI (Cd, Zn, Hg, Mn, Mg - Te, S, Se),
- les semi-conducteurs IV-VI (Pb, Sn - Te, Se), etc..

A titre d'exemple, l'hétérostructure de l'invention est réalisée en au moins un des matériaux semi-conducteurs choisi parmi :
Cd₁₋ₓ Mnₓ Te, CdₓHg₁₋ₓ Te, Cdₓ Zn₁₋ₓ Te, Cdₓ Zn_{z} Mn_{1-x-z} Te, Cdₓ Zn₁₋ₓ Se, CdS_{y} Se_{1-y}, Cdₓ Zn₁₋ₓ S_{y} Se_{1-y}, Zn_{z} Mn_{1-z} Se, Zn_{z} Mg_{1-z} S_{y} Se_{1-y}, Gaₓ Al₁₋ₓ As, Gaₓ Al₁₋ₓ N, avec 0≤x≤1, 0≤y≤1, 0≤z≤1 et 0≤x+z≤1.

Les semi-conducteurs II-VI permettent une large gamme d'ajustement de la longueur d'onde d'émission. En particulier, les cavités incluant CdHgTe peuvent émettre dans l'infrarouge, ceux incluant CdMnTe, ZnSe, ZnS, ... peuvent émettre de la lumière visible jusqu'au bleu-ultraviolet.

Pour assurer le contrôle en température de la cavité laser, celle-ci est avantageusement montée sur une masse thermique.

Avantageusement, la cavité laser peut être montée sur cette masse thermique de façon que les couches épitaxiées reposent sur cette masse. Dans ce cas, le substrat constitue la partie supérieure de la cavité laser et le rôle de création et de collection des porteurs est alors assuré par la troisième zone. Afin d'assurer le pompage extérieur sur cette troisième zone, un dégagement local du substrat et de la zone tampon doit être pratiqué.

La cavité laser à puits quantiques et à gradients de composition asymétriques de l'invention optimise le couplage entre le faisceau de pompage (optique ou électronique), le mode optique guidé et la zone de gain pour améliorer les fonctions de cette hétérostructure.

La cavité laser de l'invention peut être du type Fabry-Perot ou distribuée. Dans ce cas, elle comporte deux faces latérales parallèles entre elles et clivées, orientées perpendiculairement aux couches semi-conductrices. Des miroirs semi-réfléchissants peuvent éventuellement être déposés sur ces faces latérales. Ces miroirs semi-réfléchissants sont constitués en particulier de dépôts de matériaux diélectriques multicouches.

La cavité laser peut aussi être à guidage par le gain lumineux ou par l'indice. Dans ce cas, elle peut présenter une structure mesa définissant un ruban, être épitaxiée en plusieurs étapes avec une alternance de gravures et présenter des régions implantées, interdiffusées ou diffusées latéralement.

Une variante originale associée au pompage en ruban (par focalisation optique ou électronique) consiste en la réalisation d'un confinement latéral par un dépôt métallique (Ag, Au, Al ou autre métal approprié) sur la surface à exciter, en laissant vierge un ruban d'excitation.

Ce dépôt métallique a une triple fonction :
a) - diminution locale, sous le dépôt métallique, de l'indice effectif du guide, conduisant à un confinement latéral des modes guidés au niveau du ruban d'excitation, comme dans le cas des structures à guidage par l'indice dans les diodes laser à injection,
b) - évacuation de la chaleur produite par le pompage extérieur vers la masse thermique, afin de contrôler la température de la cavité,
c) - arrêt des électrons (pompage électronique) ou des photons (pompage optique) arrivant en dehors de la largeur du ruban de focalisation.

Ce dépôt métallique peut éventuellement être associé à une structure de type mesa ou une structure de guidage par l'indice.

La réalisation de structures à guidage par l'indice est connue (voir par exemple l'article "Laser diode modulation and noise" de K. Peterman, pages 36-37, ADOP Advances in Optoelctronics KTK Scientific Publishers).

Par ailleurs, l'utilisation d'un dépôt métallique pour le confinement latéral des modes guidés est connue pour d'autres applications qu'un laser (voir par exemple l'article "Guided-wave optoelectronics", de T. Tamin, pages 326-327, Springer Series in Electronics and Photonics 26).

En utilisant comme moyen de-pompage un canon à électrons à source à micropointes, il est possible de réaliser un microlaser de quelques cm³ de volume.

La cavité laser de l'invention peut être réalisée avec les moyens et les procédés actuellement utilisés en microélectronique pour la réalisation des lasers à semi-conducteur.

D'autres caractéristiques et avantages de l'invention ressortiront mieux de la description qui va suivre, donnée à titre illustratif et non limitatif, en référence aux figures annexées dans lesquelles :
- la figure 1A représente schématiquement en perspective une cavité laser de type Fabry-Perot, conforme à l'invention,
- la figure 1B montre l'évolution de la composition (x), de l'énergie de bande interdite (E_{g}) et de l'indice optique (Iₒ) de l'hétérostructure de la cavité de la figure 1A,
- la figure 2A donne l'évolution de la bande interdite (E_{g}) exprimée en électrons-volts et celle du paramètre de maille a exprimé en nanomètres pour les composés II-VI, utilisables dans la cavité de l'invention,
- la figure 2B donne les variations de l'indice optique pour le confinement optique dans une hétérostructure en CdTe/CdMnTe,
- les figures 3A et 3B donnent la longueur d'onde d'émission (λe) exprimée en nanomètres en fonction de la composition de la zone active pour une hétérostructure selon l'invention en CdTe/CdMnTe à respectivement 300K et 77K,
- la figure 4 illustre les variations de la composition en manganèse (x%) en fonction de la profondeur (p) exprimée en nanomètres pour une hétérostructure en Cd₁₋ₓMnₓTe, mesurées par spectroscopie SIMS,
- la figure 5 donne le profil de création des paires électrons-trous dans une cavité de l'invention pompée électroniquement par un faisceau d'électrons,
- les figures 6 et 7 illustrent deux autres variantes de réalisation de la cavité laser conforme à l'invention,
- les figures 8A à 8E illustrent différentes variantes de fixation de la cavité de l'invention sur une masse thermique,
- la figure 9 représente schématiquement un mode de réalisation d'un laser conforme à l'invention,
- la figure 10 donne les variations de la puissance laser (Pₗ), exprimée en mW en fonction de l'excitation électronique (E_{c}) du laser exprimée en kW/cm² pour une hétérostructure en GaAlAs et une hétérostructure en CdMnTe, mesurées en mode quasi-continu,
- les figures 11A et 11B donnent le spectre d'émission laser d'une hétérostructure en CdTe/CdMnTe d'une cavité de l'invention excitée par un faisceau d'électrons pour deux échelles différentes,
- la figure 12 montre les variations de la puissance de seuil laser (Pₛ) en pompage optique, exprimées en kW/cm² (échelle logarithmique) en fonction de la température (T) de fonctionnement, exprimée en degrés K pour un laser à hétérostructure en CdTe/CdMnTe de l'invention.

Sur la figure 1A, on a représenté schématiquement une cavité laser de type Fabry-Perot ou distribué conforme à l'invention. Cette cavité laser de référence générale 10 comprend, en partant de sa surface supérieure 12, vers sa surface inférieure 14 des zones 1, 2, 3 et 4 semi-conductrices épitaxiées sur un substrat semi-conducteur 16.

L'épitaxie de ces zones est réalisée de façon connue, soit par épitaxie par jet moléculaire (MBE), soit par épitaxie par dépôt chimique en phase vapeur à partir d'organométallique (MOCVD) ou par toute autre technique similaire connue.

Ces zones sont réalisées en des matériaux semi-conducteurs de type II-VI, III-V ou IV-VI à bande d'énergie interdite (ou gap) directe.

La cavité laser 10 présente la forme d'un barreau parallélépipédique dont deux faces latérales 18 et 20, parallèles entre elles et perpendiculaires aux zones épitaxiées sont obtenues par clivage de l'ensemble zones-substrat et constituent des miroirs semi-réfléchissants d'entrée et de sortie de la cavité laser. Les autres faces latérales sont non actives.

A titre d'exemple, cette cavité laser comporte un substrat 16 aminci à une épaisseur de 50 à 300µm. La largeur de la cavité laser séparant les faces non actives est obtenue par découpe de l'ensemble zones-substrat avec une scie diamantée et a une épaisseur typique de 1mm. La longueur de la cavité Fabry-Perot, c'est-à-dire la distance séparant les faces clivées 18, 20, varie entre 100-1000 µm. La valeur typique est de 500µm.

Les réflectivités des miroirs clivés sont déterminées par l'indice optique du semi-conducteur ; en général pour les semi-conducteurs II-VI ou III-V, elle est d'environ 30%.

On peut éventuellement améliorer cette réflectivité en réalisant un dépôt de multicouches diélectriques et métalliques sur les faces clivées. Ce dépôt a en outre le rôle de protéger les faces actives.

La cavité laser de l'invention est optimisée pour une excitation ou un pompage par une source extérieure de type pompage optique ou électronique. Ce pompage est symbolisé par le faisceau de particules 19 interagissant avec la structure laser selon une direction perpendiculaire aux zones épitaxiées.

Selon l'invention, la zone 1 de surface constitue à la fois la zone d'excitation de la structure, de génération de paires d'électrons-trous dues à l'interaction faisceau excitateur-matériau semi-conducteur de la zone 1 ainsi que la zone de diffusion accélérée des porteurs créés dans cette zone vers la zone active 2. De plus, la zone 1 assure la première partie du confinement optique de la lumière émise dans la zone active.

La zone 2 constitue la zone active d'émission de lumière ainsi que la zone de confinement électronique des porteurs. Cette zone active 2 est contiguë et adjacente à la zone 1 d'excitation et de confinement optique.

La zone 3 contiguë et adjacente à la zone active 2 constitue la deuxième partie de la zone de confinement optique.

La zone 4 interposée entre la zone de confinement 3 et le substrat 16 constitue la zone tampon et sert de barrière optique.

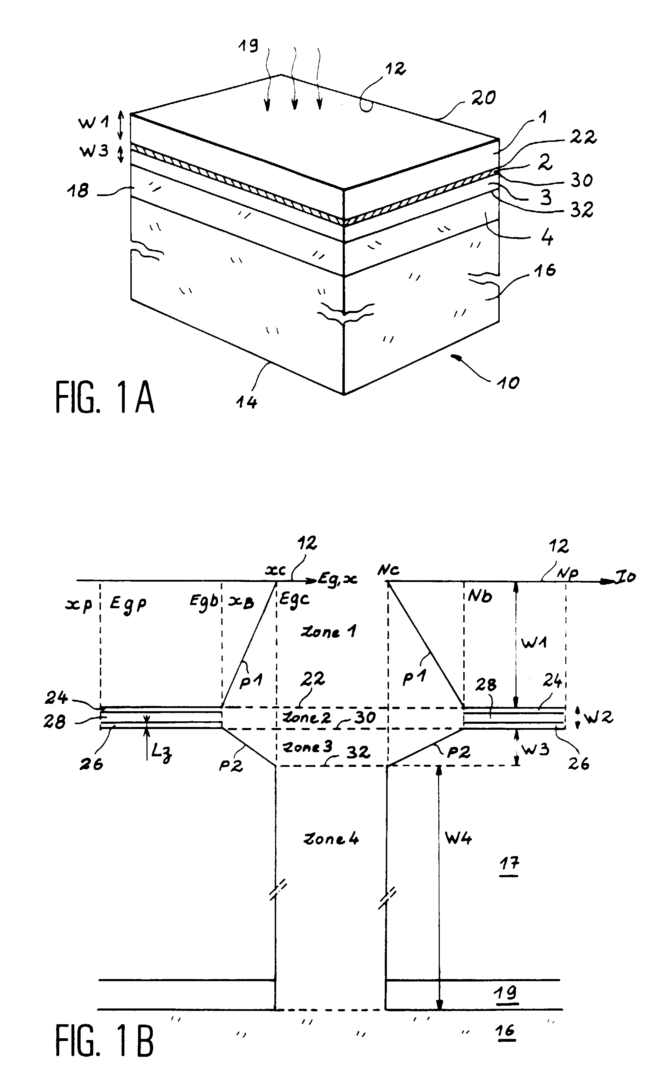

Selon l'invention et en se référant à la figure 1B, la zone 1 est réalisée en un matériau semi-conducteur dont la composition x varie continûment de la surface supérieure 12 à l'interface 22 des zones 1 et 2. Cette variation est linéaire ou quasi-linéaire. On note x_{c} la composition de la zone 1 à la surface 12 et x_{b} sa composition à l'interface 22.

La variation de la composition de la zone 1 peut être obtenue de façon connue, soit en modifiant la température de la cellule d'effusion qui produit le jet atomique ou moléculaire dans le cas d'une épitaxie MBE, soit par modifications successives de la composition du jet atomique.

Cette composition est telle que l'énergie de bande interdite E_{g} décroît linéairement (ou quasi-linéairement) de la surface 12 à l'interface 22 et qu'inversement l'indice de réfraction optique Iₒ croît linéairement (ou quasi-linéairement) de la surface 12 à l'interface 22.

On note E_{gc} et N_{c} respectivement l'énergie de bande interdite et l'indice de réfraction de la zone 1 ayant la composition x_{c} et E_{gb} et N_{b} respectivement l'énergie de bande interdite et l'indice de réfraction de la zone 2 ayant la composition x_{b}.

Selon l'invention, la zone active 2 est constituée d'un ou plusieurs puits quantiques par exemple du type super-réseau pour assurer le confinement des porteurs.

Sur la figure 1B, on n'a représenté que deux puits quantiques respectivement 24 et 26 séparés par une barrière quantique 28.

Les puits quantiques 24 et 26 sont réalisés en un matériau semi-conducteur à énergie de bande interdite E_{gp} inférieure à celle de la zone 1 au niveau de l'interface 22.

L'indice optique Nₚ de ces puits peut être quelconque et par exemple supérieur à celui de la zone 1 au niveau de l'interface 22. En effet, les puits quantiques qui sont très minces n'interviennent que très peu dans le confinement optique et le guidage de lumière. Le guidage est assuré par les zones 1 et 3.

La barrière quantique 28 doit présenter une énergie de bande interdite supérieure à celle des puits quantiques 24 et 26. Elle peut être égale ou différente de celle de la zone 1. En pratique, l'énergie de gap de la couche barrière 28 sera égale à celle de la zone 1 à l'interface 22 des zones 1 et 2.

Ceci peut être réalisé en utilisant le même matériau que celui de la zone 1 avec la composition x_{b}.

Selon l'invention, la zone 3 a une composition semi-conductrice qui varie continûment de sa surface supérieure 30 ou interface entre les zones 2 et 3 à sa surface inférieure 32 ou interface entre les zones 3 et 4. Cette composition est telle que l'énergie de bande interdite de la zone 3 croît linéairement (ou quasi-linéairement) de l'interface 30 à l'interface 32 et qu'inversement l'indice optique décroît linéairement (ou quasi-linéairement) de l'interface 30 à l'interface 32.

La zone 3 peut être réalisée en un matériau semi-conducteur différent de celui de la zone 1. Dans l'exemple représenté, on a choisi la même composition x_{c} à la surface 12 et à l'interface 32 et la même composition x_{b} aux interfaces 22 et 30.

La zone 4 peut avoir une composition constante jusqu'au substrat qui peut être identique ou différente de celle de la zone 3. Elle doit présenter une composition telle que son incide de réfraction soit au plus égal à l'indice N_{c} de la zone 3 à l'interface 32.

Elle peut aussi être constituée de deux couches distinctes : une couche 17 de confinement optique et une couche 19 d'adaptation, intercalée entre la couche 17 et le substrat.

Conformément à l'invention, l'épaisseur W₁ de la zone 1 et l'épaisseur W₃ de la zone 3 sont différentes et en particulier W₁ est supérieur à W₃. En outre, la pente p₁ de décroissance de l'énergie de gap de la zone 1 et inversement de croissance de l'indice optique de la zone 1 est différente de la pente p₂ de croissance de l'énergie de gap de la zone 3 et inversement de décroissance de l'indice optique de la zone 3.

La structure laser de l'invention est donc une structure GRINSCH à puits quantiques et à gradients de gap et d'indice. Elle est en outre asymétrique par rapport à la zone active et plus précisément par rapport à la barrière quantique 28 dans le cas représenté sur la figure 1B.

Cette structure asymétrique est adaptée spécialement pour le pompage externe électronique avec des tensions d'accélération des électrons faibles ou pour le pompage externe optique tout en ayant un bon confinement optique et électronique. L'asymétrie assure une optimisation de la structure de façon à centrer le mode optique guidé sur la zone active d'émission pour obtenir le maximum de couplage entre les photons émis dans la zone 2 et le mode guidé.

Les variations de composition des zones 1 et 3, les épaisseurs W₁ et W₃ des zones 1 et 3 ainsi que l'épaisseur W₂ de la zone active et l'épaisseur W₄ de la zone tampon 4 dépendent des différences de paramètres de maille entre les différents matériaux semi-conducteurs, de la longueur d'onde d'émission choisie ainsi que de la famille de composés choisie.

La cavité laser de l'invention peut être réalisée en des matériaux présentant ou non des désaccords de mailles importants. Lorsque de tels désaccords de mailles existent, on utilise de préférence des épaisseurs de matériaux semi-conducteurs inférieures à l'épaisseur critique, dans les zones 1, 2 et 3 de la structure ; la zone 4 peut être relaxée par rapport au substrat.

Du fait du pompage extérieur de la cavité laser de l'invention, le dopage des zones semi-conductrices peut être quelconque. En particulier, les couches semi-conductrices peuvent être non intentionnellement dopées. Ainsi, la cavité laser de l'invention peut avantageusement être réalisée en matériau II-VI. Ces matériaux permettent une large gamme d'ajustement de la longueur d'onde d'émission laser. En particulier, les matériaux incluant du CdHgTe peuvent émettre dans l'infrarouge et ceux incluant du CdMnTe, ZnSe, ZnS, CdZnSe ou ZnSSe peuvent émettre du visible jusqu'au bleu-ultraviolet.

En particulier, la cavité de l'invention peut être réalisée en Cd₁₋ₓMnₓTe avec 0≤x≤1. Dans ce cas, plus la composition en manganèse x croît, plus l'énergie de gap E_{g} croît et plus l'indice optique diminue. Ainsi, dans une réalisation particulière, les puits quantiques peuvent être réalisés en CdTe.

Pour une hétérostructure en Cd₁₋ₓMnₓTe, on peut utiliser une zone 1 de 100nm à 1µm, un ou plusieurs puits quantiques ayant chacun une largeur L_{z} allant de 0,1nm à 100nm ; une zone 3 ayant une épaisseur W₃ allant de 100nm à 1µm à condition que W₁>W₃.

Si x_{c} est la composition en manganèse de la zone 1 à la surface 12 et celle de la zone 3 à l'interface 32, x_{b} la composition en manganèse aux interfaces 22 et 30 respectivement entre les zones 1 et 2 et les zones 2 et 3 ainsi que celle de la couche barrière 28 et xₚ la composition en manganèse des puits quantiques, x_{c} , x_{b} et xₚ peuvent varier de 0 à 1 avec x_{b}-xₚ≥0,10 et que x_{c}-x_{b}≤0,10 pour assurer un saut d'indice suffisant pour le confinement optique de la lumière émise ainsi qu'une capture des porteurs.

La cavité laser peut aussi être réalisée en CdₓHg₁₋ₓTe avec 0≤x≤1. Là encore, plus x croît, plus l'énergie de bande interdite E₉ croît et l'indice optique décroît.

On peut aussi utiliser des alliages quaternaires du type CdₓZn_{z}Mn_{1-x-z}Te avec 0≤x≤1, 0≤z≤1 et 0≤x+z≤1. Des résultats publiés montrent qu'une émission jusque dans le bleu peut être observée pour des puits quantiques en CdTe séparés par des barrières en MnTe ou des puits quantiques en ZnTe séparés par des barrières en MnTe.

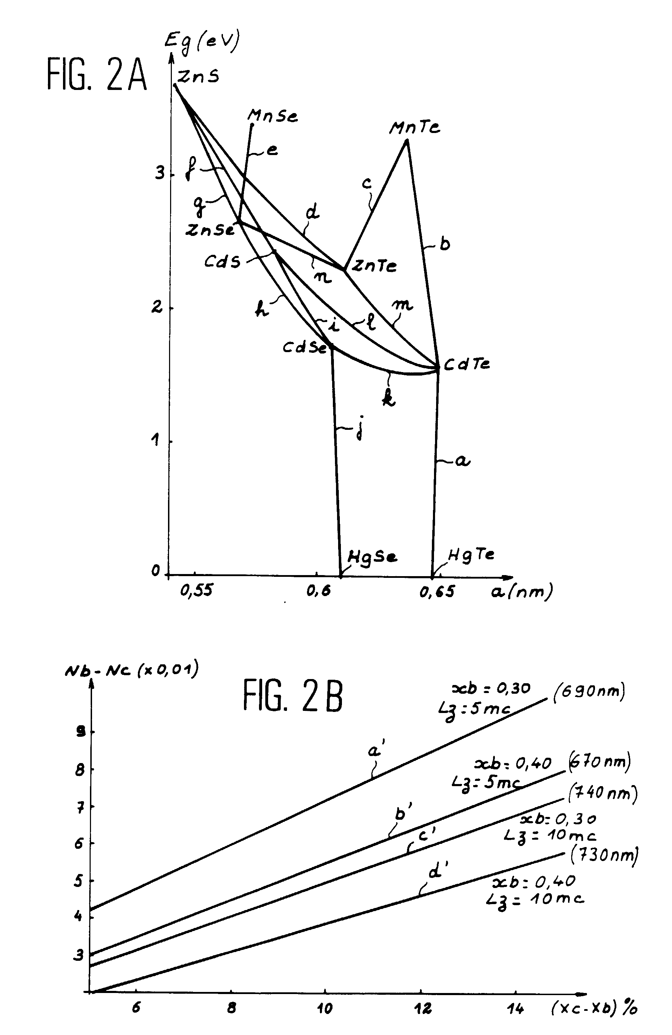

Sur la figure 2A, on a représenté les variations de l'énergie de bande interdite E_{g} exprimée en électrons-volts et du paramètre de maille a exprimé en nm pour différents composés II-VI. Sur le graphe de la figure 2, on a fait apparaître les composés binaires. Les lignes reliant deux composés binaires sont représentatives des composés intermédiaires entre ces deux composés binaires.

Par exemple la ligne a correspond aux composés CdHgTe ; la ligne b correspond aux composés CdMnTe ; la ligne c correspond aux composés ZnMnTe ; la ligne d correspond aux composés ZnTeS ; la ligne e correspond aux composés MnZnSe ; la ligne f correspond aux composés ZnCdS ; la ligne g correspond aux composés ZnSSe ; la ligne h correspond aux composés ZnCdSe ; la ligne i correspond aux composés CdSSe ; la ligne j correspond aux composés HgCdSe ; la ligne k correspond aux composés CdSeTe ; la ligne l correspond aux composés CdSTe ; la ligne m correspond aux composés ZnCdTe ; la ligne n correspond aux composés ZnSeTe.

Tous ces composés peuvent être utilisés pour réaliser la cavité de l'invention en respectant les conditions d'énergie de bande interdite (voir figure 1B) pour les puits et les barrières quantiques.

Sur la figure 2B, on a représenté des variations de l'indice optique pour le confinement optique pour une hétérostructure en CdMnTe avec des puits quantiques dans la zone active en CdTe.

Plus précisément, la figure 2B donne les variations N_{b}-N_{c} en fonction de la différence de composition x_{c}-x_{b}. Les droites a', b', c' et d' correspondent respectivement à une composition x_{b} de 0,30 ; de 0,40 ; de 0,30 ; de 0,40 et une largeur L_{z} du puits quantique respectivement de 5 monocouches ; 5 monocouches (mc) ; 10 monocouches ; et 10 monocouches. Dans le cas présent, une monocouche d'épaisseur voisine de 0,32nm représente le dépôt d'une couche d'atomes de cadmium et d'une couche d'atomes de tellure. De plus, x_{c} est ≤1.

Pour chaque courbe, la longueur d'onde d'émission est différente, ce qui induit des variations d'indice différentes. Ces longueurs d'onde sont indiquées sur la figure 2B.

On constate donc que l'indice optique croît linéairement lorsque la composition x en Mn décroît linéairement.

La limitation en épaisseur du ou des puits quantiques est donnée par l'épaisseur critique. Celles-ci sont bien connues. Pour le couple CdTe/ZnTe, le puits est limité à une épaisseur de 1,7nm et pour le couple CdTe/Cd_{0,96}Zn_{0,04} Te à quelques centaines de nm (par exemple 300nm).

En utilisant des matériaux à plus faibles désaccords de maille, comme par exemple la structure CdTe/CdMnTe, on augmente l'épaisseur critique, ce qui permet, soit d'augmenter l'épaisseur du puits quantique, soit le nombre de puits. Ceci permet aussi d'obtenir un meilleur confinement optique, soit en augmentant les épaisseurs des zones 1 et 3, soit en accentuant la variation de composition x_{c}-x_{b}.

Quelle que soit l'épaisseur du puits, le gain en lumière dans ce puits quantique reste important grâce au confinement des porteurs dans ce puits. Ainsi, le puits quantique peut être réduit à quelques couches atomiques.

La longueur d'onde d'émission dépend de la composition des puits quantiques mais surtout de la largeur de ces puits.

Ainsi, de faibles fluctuations dans l'épaisseur du puits, à l'échelle de la monocouche atomique, jouent donc un rôle fondamental dans l'élargissement spectral de la courbe de gain. Si la largeur de la courbe de gain est excessive, le gain maximum au centre de la courbe peut devenir trop faible.

Un bon contrôle de la morphologie des interfaces entre les deux matériaux qui composent le puits quantique est donc important. Ceci est assuré par les conditions de croissance par épitaxie. Dans certains cas, un traitement thermique ultérieur peut être utilisé pour diminuer la dispersion spectrale de la densité d'état qui définit la largeur spectrale de la raie d'émission et donc de la courbe de gain.

Par exemple, on peut utiliser un traitement thermique de 150 à 400°C pendant 1 à 60 minutes. Ce recuit peut se faire dans un four après l'épitaxie des différentes couches de la structure ou bien après le montage de la cavité laser dans le laser pendant la phase d'étuvage et de dégazage de l'ensemble sous bombardement électronique.

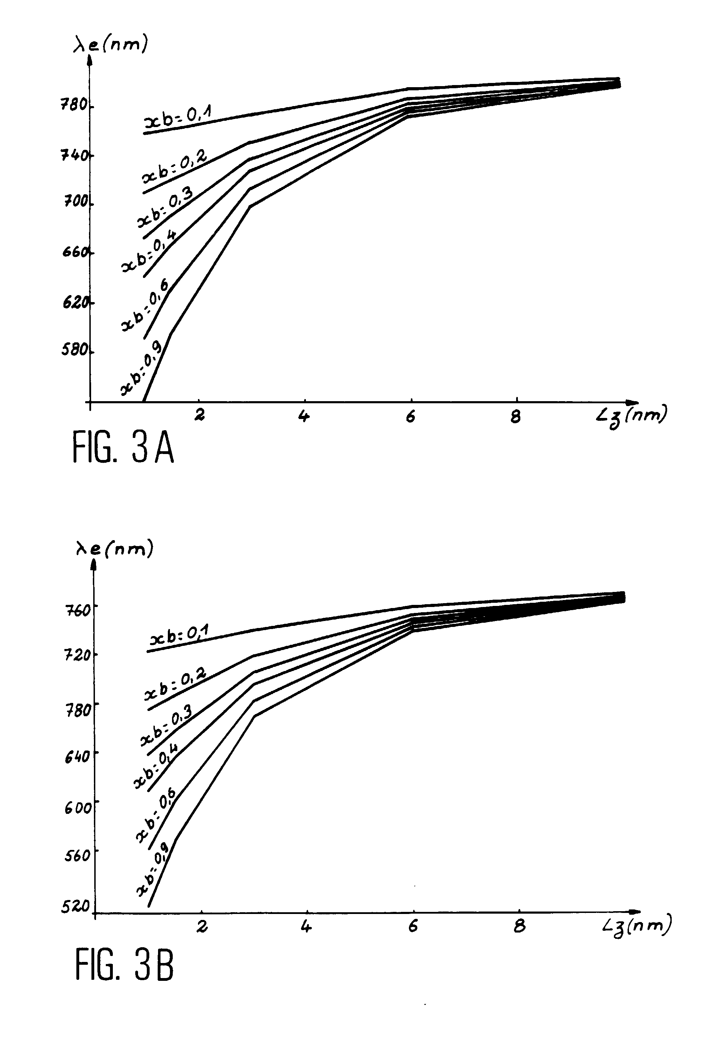

Sur les figures 3A et 3B, on a représenté les variations de la longueur d'onde d'émission λe exprimée en nanomètres pour une hétérostructure en CdTe/CdMnTe à respectivement 300K et 77K pour différentes largeurs de puits et différentes compositions de la barrière 28 entre les puits. Cette composition de la barrière 28 est aussi la composition x_{b} des zones 1 et 3 respectivement aux interfaces 22 et 30 avec la zone active. Les puits sont ici en CdTe et la surface supérieure 12 de la zone 1 et l'interface 32 entre les zones 3 et 4 sont respectivement en Cd_{1-x_{c}} Mn_{x_{c}}Te avec x_{c}-x_{b}≥0,05.

Les figures 3A et 3B sont données pour un seul puits quantique de largeur L_{z} pour la zone active.

A titre d'exemple, pour x_{b}=0,9, on obtient une émission allant de 540nm à 775nm, à 300K, pour une largeur de puits quantique allant de 1nm à 6nm.

Avec x_{b}=0,2, on obtient à 77K, une émission allant de 675 à 755nm pour une largeur de puits quantique allant de 1 à 6nm.

On constate d'après ces courbes que la longueur d'onde d'émission croît avec la largeur du puits quantique et qu'elle décroît aussi avec la valeur de x_{b}. On peut encore raccourcir la longueur d'onde d'émission en utilisant des puits quantiques en CdMnTe au lieu de CdTe.

On donne ci-après deux exemples précis de réalisation d'une cavité laser selon l'invention utilisant une hétérostructure en CdTe/Cd₁₋ₓMnₓTe.

### EXEMPLE I

La zone 1 a une épaisseur de 500nm et une composition en Mn variant continûment de la surface 12 à l'interface 22 entre les zones 1 et 2, de 0,22 à 0,17. La zone active 2 est constituée de deux puits en CdTe de 6nm chacun, séparés par une barrière de 15nm en CdMnTe avec une composition en Mn de 0,17. La zone 3 a une épaisseur de 150nm et une composition en Mn qui varie de l'interface 30 entre les zones 2 et 3 à l'interface 32 entre les zones 3 et 4, de 0,17 à 0,22.

La couche tampon 4 est une couche de 1,5µm en CdMnTe avec une composition x en Mn de 0,22. Le substrat est en CdTe d'orientation 100.

### EXEMPLE II

Cet exemple II se différencie de l'exemple I par l'utilisation d'une couche d'adaptation de maille (19) entre la couche tampon et le substrat. Cette couche d'adaptation est un super-réseau constitué de 5 puits de CdTe de 6nm d'épaisseur chacun, alternés avec 4 barrières de 15nm en CdMnTe avec une composition en Mn de 0,22.

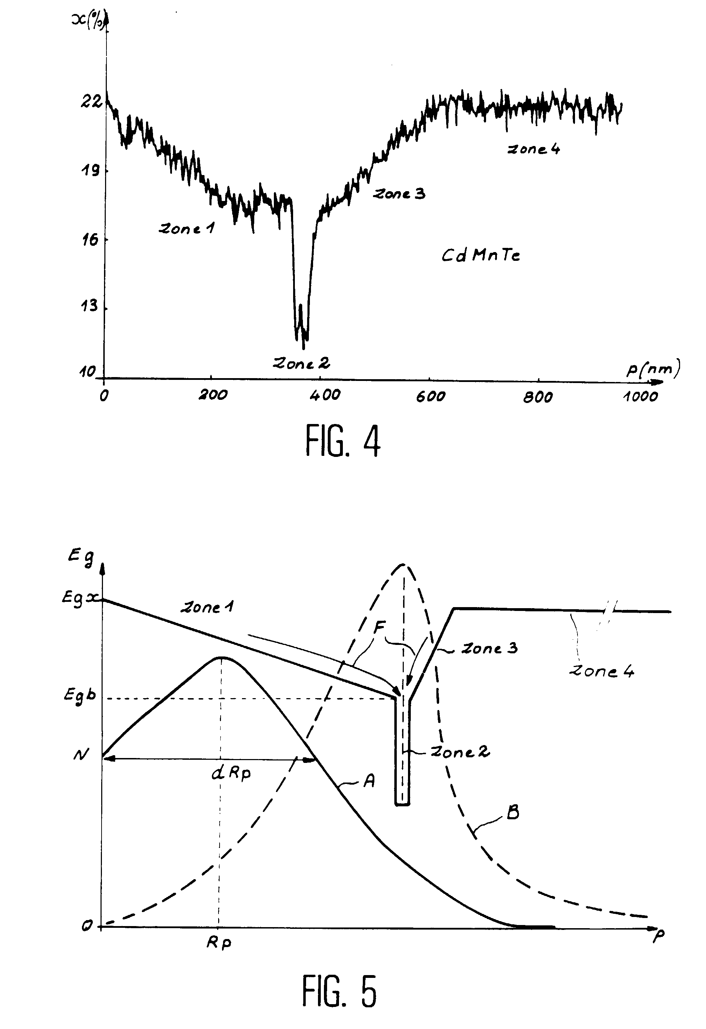

Cette structure a été contrôlée par spectroscopie SIMS. La spectroscopie obtenue est représentée sur la figure 4. Elle donne les variations de la composition x en manganèse en fonction de la profondeur p donnée en nm. Ces mesures ne sont données qu'à titre indicatif, compte tenu des problèmes d'étalonnage et de résolution propres à ce type d'analyse.

La cavité laser de l'invention peut être pompée électroniquement avec un faisceau d'électrons. Ce faisceau engendre des paires électrons-trous à une profondeur moyenne Rₚ qui augmente avec la tension d'accélération des électrons et qui dépend des matériaux semi-conducteurs de la cavité laser. Ces paires sont créées en fait sur une profondeur d_{Rp} autour de Rₚ.

Pour une efficacité maximale du pompage électronique, Rₚ et d_{Rp} doivent être accordés aux dimensions de l'hétérostructure. Ainsi, le profil de création des paires électrons-trous doit présenter son maximum dans la zone 1 de l'hétérostructure, comme cela ressort clairement de la figure 5.

La courbe A est le profil de création des paires électrons-trous et donne les variations du nombre N de paires électrons-trous en fonction de la profondeur p de l'hétérostructure. Sur cette figure 5, on a aussi représenté les variations de l'énergie de gap E_{g} de l'hétérostructure en fonction de la profondeur p. La capture de ces paires d'électrons-trous se fait au niveau des zones 1 et 3 de l'hétérostructure comme l'indiquent les flèches F.

En utilisant, conformément à l'invention, une hétérostructure de faible épaisseur (inférieure à 5µm), on peut utiliser des tensions d'accélération des électrons faibles (inférieures à 20kV), d'où un montage plus facile, plus compact et plus fiable du laser. Typiquement, on utilise un faisceau électronique de 10kV. Un tel faisceau d'électrons pour des composés II-VI a une profondeur moyenne de pénétration de 250nm et une extension d_{Rp} d'environ 400nm.

Le rôle d'acheminement des porteurs vers les puits quantiques de la zone active est particulièrement important pour des puits quantiques étroits et donc pour des structures émettant à de faibles longueurs d'onde puisqu'ils présentent une section efficace de capture plus faible que celle de puits plus larges. Ceci est notamment le cas pour une hétérostructure en CdMnTe avec des puits quantiques en CdTe.

Les variations de l'indice optique des zones 1 et 3 assurent l'existence d'un mode guidé qui a été mis en évidence par les inventeurs pour l'hétérostructure de l'exemple I par la méthode dite de "m-lines".

Un mode guidé TEO (transverse-électrique-optique) avec un indice effectif de 2,84 a été obtenu. (On rappelle que l'indice optique réel de CdTe est de 2,955 et que celui de la zone 4 en Cd_{1-x_{c}}Mn_{x_{c}}Te avec x_{c} =0,22 est de 2,825), à la longueur d'onde d'émission du laser autour de 770nm.

Ce mode guidé est défini par le gradient d'indice dans les zones 1 et 3, par le saut d'indice entre la surface 12 de l'hétérostructure et l'environnement et par le saut d'indice (lorsqu'il existe) entre la zone 3 et la couche tampon 17.

Les épaisseurs des zones 1 et 3 sont calculées pour centrer le mode TEO sur la zone 2.

Sur la figure 5, la courbe B donne les variations d'intensité du mode guidé en fonction de l'épaisseur p de l'hétérostructure.

Le confinement optique est d'autant plus grand que le saut d'indice entre les indices réels N_{c} et N_{b} des zones 1 et 3 est grand. Ceci impose des variations de composition importantes. Or, du fait de l'épaisseur critique, le saut d'indice maximum pour une hétérostructure donnée est limité. (La figure 2B montrait à titre d'exemple le saut d'indice maximum que l'on peut obtenir avec une hétérostructure en CdMnTe).

Grâce à la dissymétrie de l'hétérostructure, c'est-à-dire des zones 1 et 3, le mode guidé a son amplitude maximum au niveau de la zone active assurant ainsi un couplage optimum avec le gain en lumière.

L'hétérostructure doit être formée en épitaxie cohérente, c'est-à-dire en-dessous de l'épaisseur critique telle qu'elle peut être modélisée à partir de mesures expérimentales bien connues de l'homme de l'art.

Avec les structures des exemples I et II, une émission laser a été obtenue à température ambiante et à basse température, aussi bien avec une excitation optique à l'aide d'un laser qu'avec une excitation électronique à l'aide d'un canon à électrons utilisant une source d'électrons à micropointes comme décrit dans le document FR-A-2 661 566.

On décrit ci-après d'autres exemples de réalisation d'une cavité laser conforme à l'invention.

### EXEMPLE III : structure GaAs/GaAlAs

Cette structure présente peu de désaccord de maille et les problèmes d'épaisseur critique ne se posent pas contrairement aux structures en CdMnTe. En outre, elle présente des variations d'indice optique plus grandes et donc un meilleur confinement optique que les structures en CdMnTe. En revanche, cette structure présente une possibilité moins étendue d'ajuster la longueur d'onde d'émission qui varie très peu autour de 0,8µm.

Les zones 1 à 4 peuvent être réalisées en Ga₁₋ₓAlₓAs avec 0≤x≤1 à condition que les puits quantiques de la zone active 2 aient une composition en aluminium inférieure à celle des zones 1 et 3 pour assurer le confinement électronique. Les zones 1 et 3 peuvent avoir des épaisseurs allant de 100nm à 1000nm et la zone active une épaisseur allant de 0,5nm à 200nm en respectant la condition de dissymétrie W₁>W₃.

En particulier, il a été réalisé une hétérostructure comportant une zone 1 de 350nm d'épaisseur ayant une composition x_{c} en surface 12 en aluminium de 0,5 et une composition x_{b} à l'interface 22 avec la zone 2 de 0,20. La zone active est constituée d'un puits quantique de 10nm d'épaisseur en GaAs. La zone 3 a une composition x_{b} de 0,20 à l'interface 30 zone 2-zone 3 et une composition x_{c} à l'interface entre les zones 3 et 4 de 0,50 ; son épaisseur est de 200nm.

La zone tampon comprend une première couche tampon 17 d'épaisseur 800nm en Ga₁₋ₓAlₓAs avec x=x_{c} (soit 0,50) épitaxiée sur une couche d'adaptation constituée d'un super-réseau. Cette couche d'adaptation a une épaisseur de 150nm. Elle comporte en alternance 5 puits quantiques en GaAs de 10nm d'épaisseur chacun et 5 barrières quantiques de composition x_{c} (soit x_{c}=0,50) de 10nm d'épaisseur chacune. Le super-réseau est déposé sur une couche de GaAs de 50nm.

Le substrat est en GaAs d'orientation cristalline 100.

Conformément à l'invention, les couches de GaAlAs et de façon générale les hétérostructures de l'invention en matériau III-V sont non intentionnellement dopées.

Comme précédemment, la structure est asymétrique et la zone active est proche de la surface assurant ainsi son pompage par une source externe optique ou électronique avec un mode guidé ayant son amplitude maximum dans le puits quantique de la zone active.

### EXEMPLES IV à VI

Des hétérostructures à base de séléniure et de sulfure (voir figure 2A) ont été envisagées pour l'émission dans le bleu, sans dopage des matériaux, conformément à l'invention.

Avec un ou plusieurs puits en CdₓZn₁₋ₓSe avec x allant de 0 à 1, on peut utiliser des zones 1 et 3 de composition variable en ZnS_{y}Se_{1-y} avec 0≤y≤1 (exemple IV).

Pour des puits quantiques dans la zone active en CdS_{y}Se_{1-y} avec 0≤y≤1, on peut utiliser des compositions variables en CdSSe pour les zones 1 et 3 (exemple V) à condition que ces zones 1 et 3 aient une bande d'énergie interdite supérieure à celle du puits quantique (E_{g} augmentant linéairement avec y).

On peut aussi réaliser une hétérostructure en Zn_{z}Mn_{1-z}Se avec 0≤z≤1 (exemple VI) en respectant les valeurs d'énergie de bande interdite des zones 1, 2 et 3 (E_{g} augmentant lorsque la composition en Mn augmente).

Dans ces hétérostructures il faut aussi tenir compte des contraintes d'épaisseur critique comme dans les structures en CdMnTe.

### EXEMPLES VII à IX

Des hétérostructures en matériau semi-conducteur quaternaire II-VI ont aussi été envisagées. Ces hétérostructures utilisent les matériaux suivants : CdₓZn_{z}Mn_{1-x-z}Te, CdₓZn₁₋ₓS_{y}Se_{1y} et Zn_{z}Mg_{1-z}S_{y}Se_{1-y} avec 0≤x≤1, 0≤y≤1, 0≤z≤1 et 0≤x+z≤1.

### EXEMPLES X à XIII

Ces exemples concernent des émissions laser dans l'infrarouge.

Des lasers émettant dans l'infrarouge peuvent être réalisés à partir des matériaux II-VI incluant le mercure comme les matériaux en CdₓHg₁₋ₓTe avec x allant de 0 à 1 (exemple X) ou à partir de matériaux IV-VI de type PbₓSn₁₋ₓTe (exemple XI), PbₓEu₁₋ₓSe (exemple XII), PbₓEu₁₋ₓSe_{y}Te_{1-y} (exemple XIII) avec x allant de 0 à 1 et y allant de 0 à 1 avec 0≤x+y≤1.

Dans les hétérostructures en CdHgTe, on utilise en particulier des puits quantiques en CdHgTe. Avec ces matériaux, les problèmes d'épaisseur critique sont secondaires.

Avec les lasers émettant dans l'infrarouge, et en particulier ceux dont la longueur d'onde d'émission est supérieure à 1µm, on peut utiliser des diodes laser en matériau III-V émettant autour de 800nm comme source de pompage extérieur.

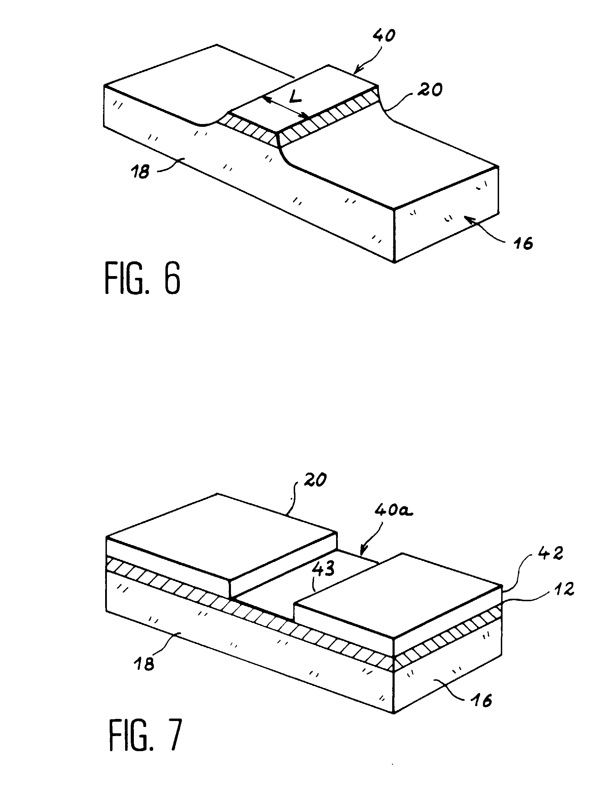

Conformément à l'invention d'autres types de cavités laser que celui de la figure 1A peuvent être envisagés. En particulier la cavité de l'invention peut présenter une structure mesa telle que représentée sur la figure 6. Dans ce cas, les couches épitaxiées (zones 1 à 4) et éventuellement une partie du substrat 16 sont gravées par voie chimique, humide ou sèche, pour réaliser un ruban 40 s'étendant des faces clivées 18 et 20, selon une direction perpendiculaire à ces faces. La largeur L du ruban peut varier de 2µm à 50µm et la valeur typique est de 5 à 10µm.

La gravure des couches épitaxiées permet un confinement latéral de la zone d'excitation de la cavité laser.

La cavité laser de l'invention peut aussi avoir la structure représentée sur la figure 7. Dans ce mode de réalisation, le ruban 40a destiné au confinement de l'excitation électronique ou optique externe est obtenu par un dépôt métallique 42 à la surface 12 de l'empilement des couches épitaxiées. Ce dépôt est équipé d'une ouverture 43 en forme de ruban dans sa partie médiane.

Le ruban 40a est encore ici orienté perpendiculairement aux faces clivées 18 et 20. Ses caractéristiques sont identiques à celles décrites en référence à la figure 6.

L'épaisseur de la couche 42 est supérieure à 20nm. Le métal utilisé peut être de l'argent, de l'or, de l'aluminium.

Ce dépôt métallique gravé, en plus du confinement latéral, assure l'évacuation de l'énergie excédentaire provenant de la chaleur produite par le faisceau de pompage. En outre, il peut arrêter les électrons ou les photons, selon le type de pompage utilisé, qui sont émis en dehors du ruban 40a d'excitation.

Lorsque le dépôt 42 est utilisé pour le refroidissement ou le filtrage spatial du faisceau d'électrons ou de photons, son épaisseur doit être suffisante d'une part pour arrêter les électrons ou les photons et d'autre part pour assurer une bonne conduction thermique. Dans ce cas, la couche 42 a une épaisseur allant de 0,2 à 2µm.

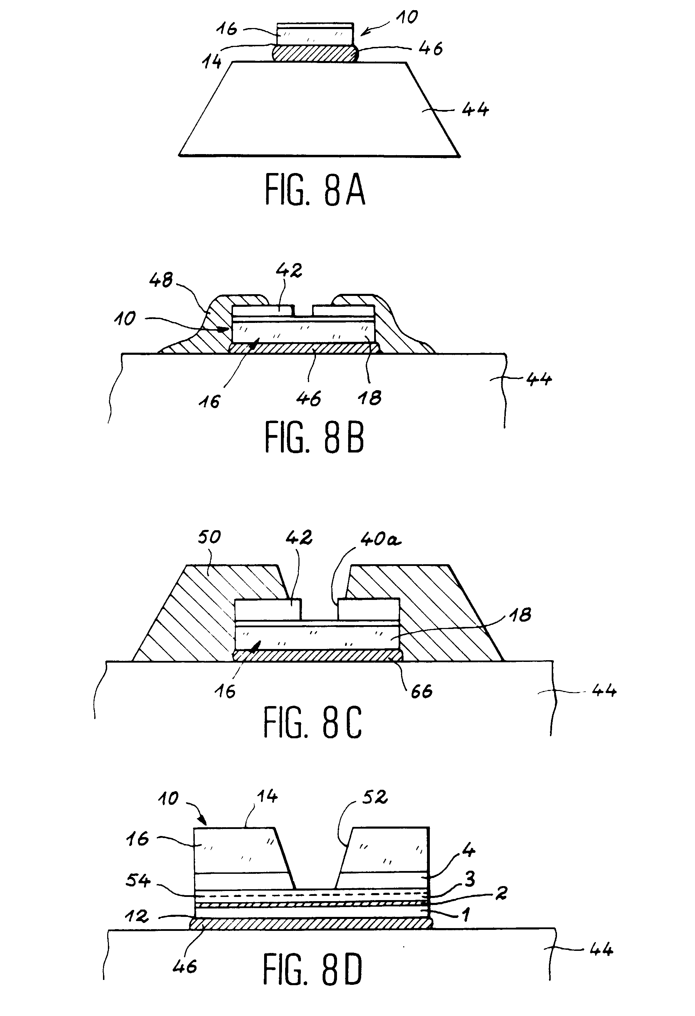

Conformément à l'invention, la cavité laser 10 de l'invention est montée sur une masse thermique comme représenté sur les figures 8A à 8E. Cette masse thermique porte la référence 44. Elle est réalisée en un métal bon conducteur de la chaleur et notamment en cuivre.

Sur la figure 8A, la cavité laser 10 est fixée par sa surface inférieure 14 sur la masse 44 à l'aide d'une soudure 46 par exemple en indium ou d'une colle conductrice de la chaleur et de l'électricité.

L'adhérence de la soudure 46 à l'indium peut être assurée en déposant successivement sur la face 14 inférieure de la cavité laser une couche de chrome d'environ 10 à 50nm puis une couche d'or d'environ 50 à 200nm, puis une couche d'indium utilisée pour la soudure avec une épaisseur de 0,05 à 2µm. Un dépôt d'indium est aussi réalisé de la même manière sur la masse thermique 44.

Après positionnement de la cavité laser 10 équipée de ses trois couches métalliques, sur la masse 44, on effectue un chauffage de l'ensemble à une température de 160 à 180°C afin d'assurer la fusion de l'indium puis on laisse refroidir l'ensemble jusqu'à la température ambiante. Le chauffage peut en outre jouer le rôle du recuit thermique de l'hétérostructure.

Lorsqu'un dépôt métallique 42 gravé est utilisé pour le confinement latéral de l'excitation, on peut monter la cavité 10 sur la masse thermique 44, comme représenté sur la figure 8B. Dans ce cas, en plus de la soudure 46 par la face arrière 14 de la cavité, on peut utiliser un dépôt d'indium 48 sur la métallisation de confinement 42 ainsi que sur les faces latérales non actives (c'est-à-dire perpendiculaires aux faces clivées) de la cavité laser.

On peut aussi remplacer la soudure de surface 48 à l'indium par des pièces métalliques 50 tel que représenté sur la figure 8C. Ces pièces 50 sont par exemple en cuivre.

Bien entendu, la soudure à l'indium 48 et les pièces métalliques 50 doivent comporter une ouverture en regard du ruban excitateur 40a.

Dans une variante de montage originale, représentée sur la figure 8D, et en vue d'obtenir un refroidissement très efficace de la cavité laser 10, le montage de la masse thermique 44 peut se faire à l'inverse des figures 8A et 8C. Autrement dit, les couches épitaxiées reposent sur la masse thermique 44, la fixation étant assurée par la soudure 46 en appui sur la surface supérieure 12.

Dans ce type de montage inversé, on peut envisager, comme dans les variantes des figures 8B et 8C, une métallisation 48 ou 50 (non représentée) prenant appui sur la surface 14 et donc sur le substrat 16 de la cavité 10.

Afin d'assurer un pompage optique ou électronique avec une source externe, la cavité laser de l'invention doit alors comporter un dégagement 52 jusqu'à la zone 3. Ce dégagement 52 est obtenu par gravure locale chimique du substrat 16 et de la zone 4 sur toute leur épaisseur.

Dans ce cas de fonctionnement, la zone 3 sert de zone d'excitation et de collection. Les rôles des zones 1 et 3 sont inversés par rapport au cas normal d'excitation sur la surface 12. En particulier, les épaisseurs W₁ et W₃ respectivement des couches 1 et 3 doivent être spécialement calculées pour ce cas inversé avec W₃>W₁.

Afin de faciliter la gravure de la zone 4, une couche d'arrêt de gravure 54 capable de résister aux agents de gravure de la zone 4 peut être intercalée entre la zone 3 et la zone 4 comme représenté sur la figure 8D. Elle doit donc être réalisée en un matériau différent de celui de la zone 3.

Pour une hétérostructure en CdMnTe, la couche 54 peut être réalisée en CdMnTe avec une concentration en Mn plus élevée que celle de la couche 4 et présenter une épaisseur de 10 à 500nm. Pour une hétérostructure en GaAlAs, on utilise du GaAlAs avec une concentration en Al différente de celle de la couche 4.

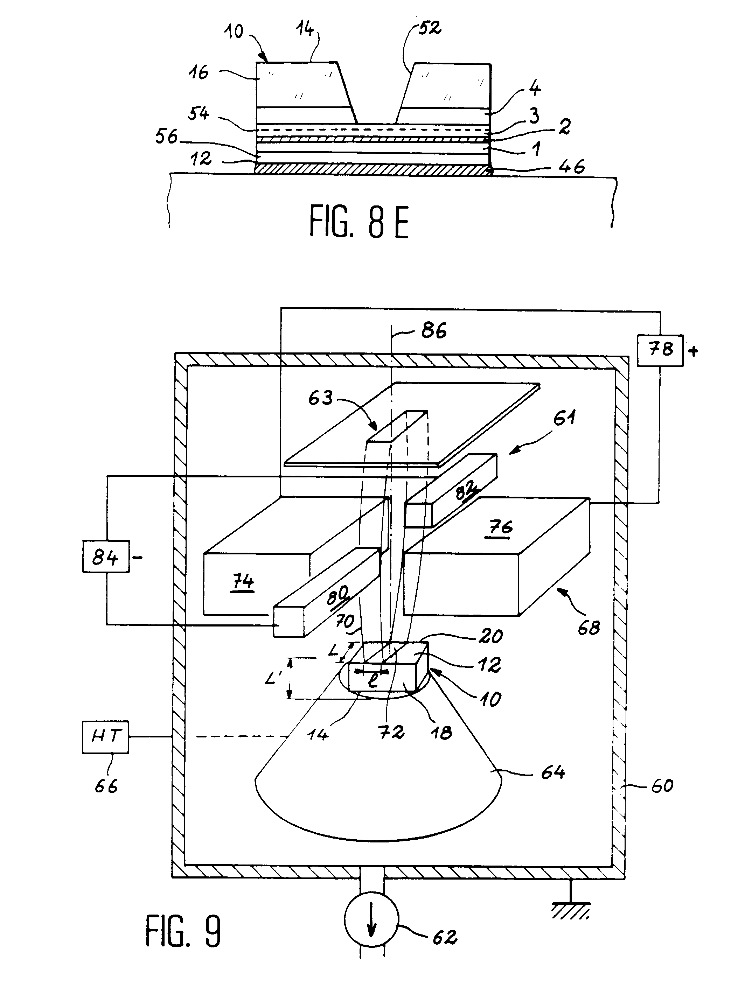

Dans ce type de montage inversé, on peut aussi, comme représenté sur la figure 8E, déposer une couche supplémentaire 56 sur la zone 1, afin de l'éloigner de la surface 12 en contact avec la soudure 46. Cette couche 56 peut avoir les mêmes caractéristiques que la zone 4. Dans ce cas, l'asymétrie de la structure est aussi inversée avec W₃>W₁.

Le pompage optique des hétérostructures en CdMnTe, GaAlAs ou en alliages quaternaires cités précédemment, peut être réalisé avec un laser émettant dans le visible (par exemple à 532nm avec un laser YAG doublé ou avec un laser à argon émettant dans le bleu-vert).

Dans le cas d'un pompage électronique, on peut utiliser un canon à électrons classique ou un canon à électrons équipé d'une source à micropointes.

Un laser à canon à électrons à source à micropointes comportant une hétérostructure de l'invention est représenté sur la figure 9. Ce laser comporte une enceinte à vide 60 équipée d'une pompe à vide 62, et de fenêtres, non représentées, pour assurer la sortie de l'émission laser produite par la cavité 10. L'enceinte pourraît aussi être scellée sous vide pour permettre un fonctionnement autonome sans pompe à vide. L'enceinte 60 est portée, par exemple, au potentiel de la masse.

Le canon à électrons 61 pour l'excitation de la cavité 10 comporte une source froide 63 à micropointes dont la structure exacte est celle décrite dans le document FR-A-2 661 566. Elle est constituée d'un réseau ou matrice de micropointes en molybdène, supportées par des électrodes cathodiques ayant la forme de bandes parallèles. Des grilles, isolées des électrodes cathodiques et ayant aussi la forme de bandes parallèles, sont agencées perpendiculairement aux électrodes cathodiques et pourvues d'ouvertures en regard des micropointes.

La cavité 10 est montée sur une anode 64 portée à la haute tension grâce à une source externe 66.

Entre l'anode 64 et la source froide 63, on trouve un ensemble 68 d'électrodes destiné à focaliser, sur la surface supérieure 12 ou sur la zone 3 (figure 8D) de la cavité laser, le faisceau d'électrons 70 émis par la source 63.

Cet ensemble 68 est agencé pour que le faisceau d'électrons 70 frappe la surface en regard de la cavité 10 sous la forme d'un ruban 72 dont la longueur L' est au minimum égale à la distance séparant les faces actives 18 et 20 de la cavité laser et dont la largeur l est comprise entre 5 et 200µm.

Cet ensemble d'électrodes 68 est agencé pour en outre servir d'écran électrostatique à la source froide contre la haute tension appliquée à l'anode 64. A cet effet, il comporte au moins deux paires d'électrodes de dimensions distinctes : une première paire 74 et 76 portée à une source externe d'alimentation électrique positive 78 et une seconde paire 80, 82 connectée à une source externe d'alimentation électrique négative 84.

Les électrodes 74 et 76 sont disposées de façon symétrique par rapport à l'axe 86 longitudinal du canon à électrons. Il en est de même pour les électrodes 80 et 82.

On donne ci-après un exemple de fonctionnement du laser de la figure 9 conforme à l'invention.

La cavité laser 10 est portée à une tension positive de 3 à 10kV par l'intermédiaire de l'anode 64.

Le faisceau d'électrons 70 créé par la source 63 puis focalisé par l'ensemble d'électrodes 68 sous la forme d'un ruban crée dans la zone 1 de la cavité 10 des paires d'électrons-trous qui sont capturées par la zone active à puits quantiques. Ces paires d'électrons-trous se recombinent dans la zone active pour donner naissance à une lumière dont la longueur d'onde dépend de l'hétérostructure de la cavité laser. Pour les structures en CdMnTe, l'émission se fait entre le rouge et le bleu-vert.

Pour une densité de paire électrons-trous, au-delà d'un certain seuil qui dépend de l'hétérostructure, l'émission stimulée a lieu et un gain optique apparaît. Les photons émis dans la zone active sont confinés dans la cavité laser et si le gain optique est suffisamment élevé pour compenser les pertes, alors l'émission laser a lieu. Le gain net nécessaire au seuil laser est typiquement de 20 à 40cm⁻¹. La densité de puissance, au seuil laser, est typiquement de 1 à 20kW/cm².

La puissance totale "P" reçue par la cavité laser dépend beaucoup de la focalisation du faisceau, et en particulier, de la largeur l du ruban d'excitation. Pour une cible donnée, de longueur L (longueur de la cavité Fabry-Perot), et pour une densité électronique utile D, la puissance sera donnée par P=D.L.l.

Pour une tension d'accélération V donnée, appliquée à l'anode, le courant électronique I est défini par I=D.L.l/V.

### EXEMPLE NUMERIQUE

Avec V=10kV, L=600µm et D=2kW/cm² , on a :
- pour l=150µm, P=1,8W et I=180µA, et
- pour l=10µm, P=120mW et I=12µA.

Ces valeurs numériques montrent qu'une bonne focalisation, correspondant à la largeur l de ruban minimum, permet :
- de diminuer la puissance totale fournie par le canon, et donc de simplifier son refroidissement,
- de tolérer des densités de seuil laser plus élevées du fait que l'on peut augmenter, à puissance égale, la densité de courant d'excitation par une bonne focalisation du faisceau d'électrons,
- de diminuer notablement le courant de fonctionnement du laser et donc de moins solliciter la source à micropointes.

La chaleur dégagée par le bombardement électronique est évacuée par la masse thermique qui peut être associée à un élément Peltier ou à un cryostat.

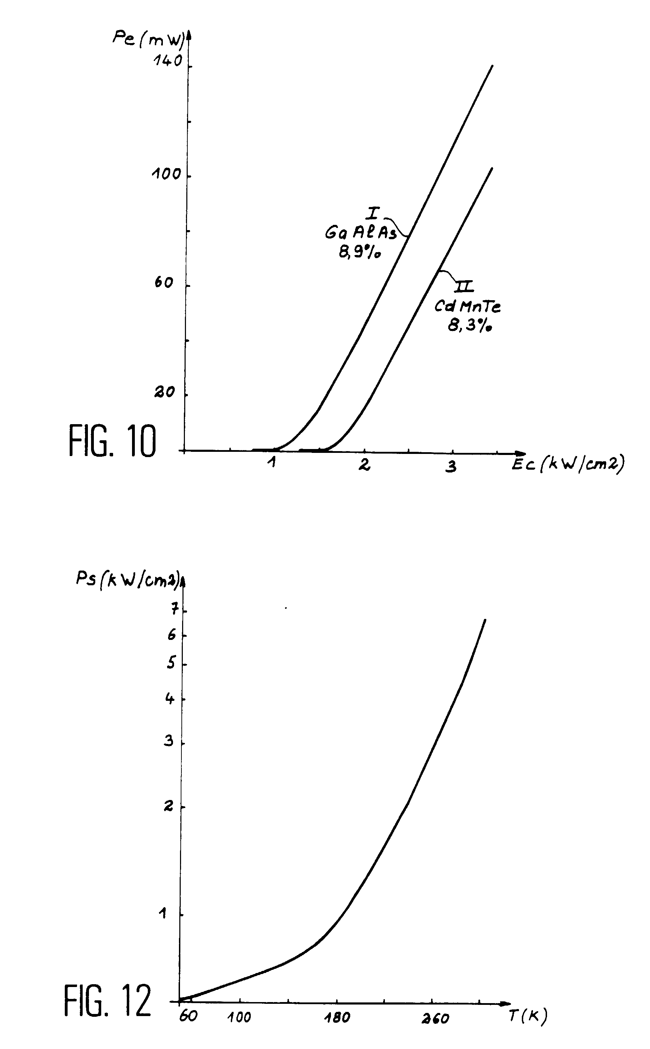

La figure 10 montre un résultat typique de fonctionnement de deux cavités laser de type Fabry-Perot en GaAs/GaAlAs émettant vers 830nm et en CdTe/CdMnTe émettant vers 760nm. Cette figure donne les variations de la puissance laser Pₗ, exprimée en mW, en fonction de l'excitation électronique E_{c} exprimée en kW/cm².

La courbe I est relative au GaAlAs et la courbe II au CdMnTe. Les cavités laser sont celles des exemples II et III. Ces puissances laser ont été établies à 90K environ, pour une tension d'accélération des électrons de 10kV et un ruban de 150µm/600µm. Le canon à électrons est celui de la figure 9.

Les puissances émises sont de quelques centaines de milliwatts avec des rendements différentiels de 8,9% pour GaAlAs et de 8,3% pour CdMnTe.

Les seuils laser sont respectivement de 1 et 1,5kW/cm² environ. Ces seuils augmentent d'un facteur 5 à 10 à la température ambiante. Pour le laser du document FR-A-2 661 566, le seuil laser est de quelques dizaines de kW/cm² et dans le document "Electron beam pumped II-VI lasers" de S. Colak et al., déjà cité, les seuils annoncés sont de quelques centaines de kW/cm², c'est-à-dire beaucoup plus élevés que ceux du laser de l'invention.

La puissance reçue par la cavité laser étant élevée (quelques watts), le fonctionnement du laser est quasi-continu. Des impulsions électroniques de 5µs espacées de 250 à 500µs permettent ce fonctionnement en quasi-continu tout en assurant le refroidissement de la cavité.

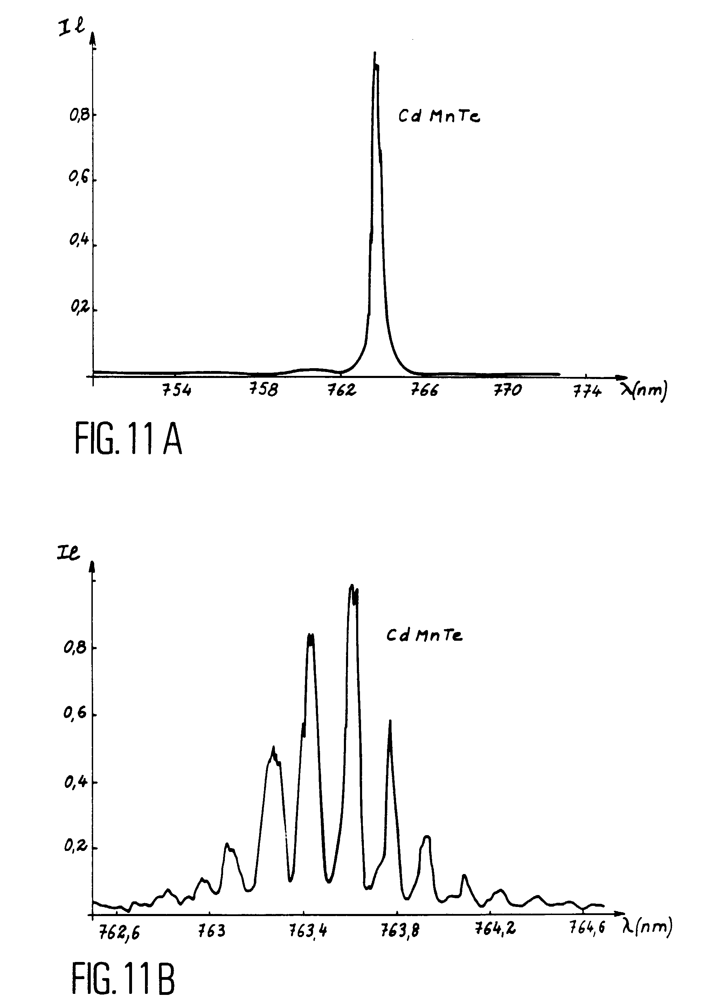

Sur les figures 11A et 11B, on donne le spectre d'émission d'une cavité laser selon l'exemple I. Ces courbes donnent l'intensité laser Iₗ donnée en unité arbitraire en fonction de la longueur d'onde λ exprimée en nanomètres. La figure 11B est un agrandissement de la figure 11A au niveau du pic d'émission.

La figure 11A montre l'affinement de la raie d'émission et l'augmentation brutale de l'intensité laser à partir de 763nm. La figure 11B montre le détail de cette raie d'émission. Ces courbes ont été tracées pour un laser tel que représenté sur la figure 9, fonctionnant à 90K et en utilisant un faisceau d'électrons de 10kV.

Des résultats identiques ont été obtenus pour un pompage optique sur une même cavité laser en CdMnTe. Les résultats sont portés sur la figure 12. Elle donne les variations de la puissance seuil Pₛ exprimée en kW/cm² en fonction de la température T de fonctionnement du laser exprimée en degrés K. La longueur d'onde d'excitation est dans ce cas 532nm.

## Revendications

1. Cavité laser à hétérostructure semi-conductrice comportant des couches semi-conductrices épitaxiées sur un substat, définissant quatre zones :
- une première zone (1) de composition variant continûment d'une première face (12) à une seconde face (22) avec une bande d'énergie interdite qui décroît de la première à la seconde face, cette première zone assurant un confinement optique et le guidage de lumière,
- une seconde zone (2) constituant une zone active d'émission, située au contact de la seconde face de La première zone, ayant au moins un puits quantique (24, 26) de bande d'énergie interdite inférieure à celle de la première zone,
- une troisième zone (3) ayant une bande d'énergie interdite supérieure celle du ou des puits quantiques, cette troisième zone assurant un confinement optique et le guidage de lumière et sa composition variant continûment d'une première (30) à une seconde face (32) avec une bande d'énergie interdite qui croît de la première à La seconde face, la première face de la troisième zone étant au contact de la zone active,
- une quatrième zone (4) constituant une zone tampon située au contact de La seconde face de La troisième zone et du substrat (16), cette quatrième zone servant de barrière optique pour le guidage de lumière,
les bandes d'énergie interdites de la première et de la troisième zone étant dissymétriques en tous points par rapport à la zone active, et la première et la troisième zone définissant avec la zone active une structure de type GRINSCH dissymétrique de telle manière que la dissymétire assure un centrage d'un mode optique guidé sur la zone active d'émission afin d'obtenir le maximum de couplage entre les photons émis et le mode guidé, l'une des première et troisième zones assurant en outre une excitation électronique et une création de paires électrons-trous avec la dissymétrie assurant en outre une optimisation de la collection et du confinement des porteurs crées et l'une des première et troisième zones constituant une des surfaces de l'hétérostructure.

2. Cavité laser selon la revendication 1, caractérisée en ce que la zone tampon (4) comporte une couche tampon (17) servant de barrière optique au contact de la seconde zone et une couche d'adaptation (19) au contact du substrat.

3. Cavité laser selon l'une quelconque des revendications 1 et 2, caractérisée en ce que la zone tampon (4) comporte une structure en super-réseau comprenant une alternance de puits quantiques et de barrières quantiques.

4. Cavité laser selon l'une quelconque des revendications 1 à 3, caractérisée en ce que la première zone (1) a une épaisseur supérieure à l'épaisseur de la troisième zone (3).

5. Cavité laser selon l'une quelconque des revendications 1 à 4, caractérisée en ce que la première zone (1) a une épaisseur au plus égale à 1µm.

6. Cavité laser selon l'une quelconque des revendications 1 à 5, caractérisée en ce que la composition de la première zone au niveau de la première face est identique à la composition de la troisième zone au niveau de sa seconde face et en ce que la composition de la première zone au niveau de sa seconde face est identique à la composition de la troisième zone au niveau de sa première face.

7. Cavité laser selon la revendication 6, caractérisée en ce que la zone active (2) comporte au moins une barrière quantique (28) ayant une composition identique à celle de la première et troisième zones respectivement au niveau de leur seconde et première faces.

8. Cavité laser selon l'une quelconque des revendications 1 à 7, caractérisée en ce que l'hétérostructure est équipée de moyens (40, 40a) assurant un confinement latéral en ruban de l'excitation électronique.

9. Cavité laser selon l'une quelconque des revendications 1 à 8, caractérisée en ce que la première face de la première zone est équipée d'un dépôt métallique (42) comportant une ouverture en forme de ruban dans une partie médiane, constituant des moyens de confinement latéral de l'excitation électronique.

10. Cavité laser selon l'une quelconque des revendications 1 à 9, caractérisée en ce que la cavité laser comporte deux faces latérales (18, 20) parallèles clivées constituant des miroirs semi-réfléchissants.

11. Cavité laser selon l'une quelconque des revendications 1 à 10, caractérisée en ce que l'hétorostructure est réalisée en au moins un matériau semi-conducteur choisi parmi :
Cd₁₋ₓ Mnₓ Te, Cdₓ Hg₁₋ₓ Te, Cdₓ Zn₁₋ₓ Te, Cdₓ Zn_{z} Mn_{1-x-z} Te, Cdₓ Zn₁₋ₓ Se, ZnS_{y} Se_{1-y} , CdS_{y} Se_{1-y} , Cdₓ Zn₁₋ₓ S_{y} Se_{1-y}, Zn_{z} Mn_{1-z} Se, Zn_{z} Mg_{1-z} S_{y} Se_{1-y} , Gaₓ Al₁₋ₓ As, Gaₓ Al₁₋ₓ N, Pbₓ Sn₁₋ₓ Te, Pbₓ Eu₁₋ₓ Se, Pbₓ Eu₁₋ₓ Se_{y} Te_{1-y} avec 0≤x≤1, 0≤y≤1, 0≤z≤1 et 0≤x+z≤1.

12. Méthode de fabrication d'une cavité laser selon l'une quelconque des revendications 1 à 11, caractérisée en ce que l'hétérostructure est soumise à un traitement thermique de 150 à 400°C pour faire interdiffuser lesdites couches semi-conductrices.

13. Laser à semi-conducteur comportant une cavité laser (10) et des moyens de pompage de la cavité, caractérisé en ce que la cavité est conforme à l'une quelconque des revendications 1 à 11.

14. Laser selon la revendication 13, caractérisé en ce que les moyens de pompage consistent en un canon à électrons (63, 64, 68).

15. Laser selon la revendication 14, caractérisé en ce que le canon à électrons comporte une source froide à micropointes (63) pour émettre un faisceau d'électrons (76), une anode (64) haute tension pour accélérer les électrons et un ensemble d'électrodes (68) assurant la focalisation en ruban du faisceau d'électrons sur la cavité laser.

16. Laser selon l'une quelconque des revendications 13 à 15, caractérisé en ce que la cavité laser (10) est montée sur une masse thermique (44), assurant le contrôle en température de la cavité laser.

17. Laser selon l'une quelconque des revendications 13 à 16, caractérisé en ce que la cavité laser est montée sur une masse thermique avec les couches épitaxiées reposant sur ladite masse, un dégagement local du substrat et de la zone tampon étant alors pratiqué pour assurer le pompage au niveau de la troisième zone.

18. Laser selon la revendication 17, caractérisé en ce que la cavité laser est fixée par soudure ou collage sur la masse thermique.

19. Laser selon la revendication 18, caractérisé en ce que la cavité laser comporte une couche de surface (56) qui éloigne la première zone (1) de la soudure ou collage sur la masse thermique.

20. Laser selon l'une quelconque des revendications 17 à 19, caractérisé en ce que la cavité laser comporte une couche d'arrêt de gravure (54) en matériau semi-conducteur entre la zone tampon et la troisième zone.

## Patentansprüche

1. Laserresonator mit asymmetrischer Halbleiter-Heterostruktur, auf ein Substrat epitaxierte Halbleiterschichten umfassend, die vier Zonen definieren:
- eine erste Zone (1), deren Zusammensetzung stetig variiert von einer ersten Fläche (12) zu einer zweiten Fläche (22) mit einem verbotenen Energieband, das von der ersten zur zweiten Fläche abnimmt, wobei diese erste Zone eine optische Einschließung und die Leitung des Lichts sicherstellt,
- eine zweite Zone (2), eine aktive Emissionszone bildend, in Kontakt mit der zweiten Fläche der ersten Zone befindlich, wenigstens einem Potentialtopf (24, 26) aufweisend mit einem niedrigeren verbotenen Energieband als dem der ersten Zone,
- eine dritte Zone (3) mit einem höheren verbotenen Energieband als dem des Potentialtopfes oder der Potentialtöpfe, wobei diese dritte Zone eine optische Einschließung und die Leitung des Lichts sicherstellt und ihre Zusammensetzung stetig variiert von einer ersten Fläche (30) zu einer zweiten Fläche (32) mit einem verbotenen Energieband, das von der ersten zur zweiten Fläche zunimmt, wobei die erste Fläche der dritten Zone in Kontakt ist mit der aktiven Zone,
- eine vierte Zone (4), eine Pufferzone bildend, in Kontakt mit der zweiten Fläche der dritten Zone und dem Substrat (16) befindlich, wobei diese vierte Zone als optische Barriere für die Lichtleitung dient,
wobei die verbotenen Energiebänder der ersten und der dritten Zone in allen Punkten asymmetrisch sind in bezug auf die aktive Zone und die erste und die dritte Zone mit der aktiven Zone eine asymmetrische Struktur des Typs GRINSCH bilden, so daß die Asymmetrie eine Zentrierung einer geleiteten optischen Mode auf die aktive Emissionszone gewährleistet, um zwischen den emittierten Photonen und der geleiteten Mode das Kopplungsmaximum zu erreichen, und eine der ersten und dritten Zonen außerdem eine Elektronenanregung und eine Erzeugung von Elektronen-Löcher-Paaren mit der Asymmetrie gewährleistet, die außerdem eine Optimierung der Sammlung und Einschließung der erzeugten Ladungsträger sicherstellt und eine der ersten und dritten Zonen eine der Oberflächen der Heterostruktur bildet.

2. Laserresonator nach Anspruch 1, dadurch gekennzeichnet, daß die Pufferzone (4) eine als optische Barriere dienende Pufferschicht (17) in Kontakt mit der zweiten Zone und eine Adaptionsschicht (19) in Kontakt mit dem Substrat umfaßt.

3. Laserresonator nach einem der Ansprüche 1 und 2, dadurch gekennzeichnet, daß die Pufferschicht (4) eine Supergitterstruktur mit einer Wechsel folge von Potentialtöpfen und Potentialbarrieren umfaßt.

4. Laserresonator nach einem der Ansprüche 1 bis 3, dadurch gekennzeichnet, daß die erste Zone (1) eine Dicke aufweist, die größer ist als die Dicke der dritten Zone (3).

5. Laserresonator nach einem der Ansprüche 1 bis 4, dadurch gekennzeichnet, daß die erste Zone (1) eine Dicke von höchstens gleich 1µm hat.

6. Laserresonator nach einem der Ansprüche 1 bis 5, dadurch gekennzeichnet, daß die Zusammensetzung der ersten Zone in Höhe der ersten Fläche identisch ist mit der Zusammensetzung der dritten Zone in Höhe ihrer zweiten Fläche, und dadurch, daß die Zusammensetzung der ersten Zone in Höhe ihrer zweiten Fläche identisch ist mit der Zusammensetzung der dritten Zone in Höhe ihrer ersten Fläche.

7. Laserresonator nach Anspruch 6, dadurch gekennzeichnet, daß die aktive Zone (2) wenigstens eine Potentialbarriere (28) mit einer Zusammensetzung aufweist, die identisch ist mit der ersten und der dritten Zone, jeweils in Höhe ihrer zweiten und ersten Flächen.

8. Laserresonator nach einem der Ansprüche 1 bis 7, dadurch gekennzeichnet, daß die Heterostruktur mit Einrichtungen (40, 40a) ausgestattet ist, die eine seitliche Einschließung mit einem Elektronenanregungsstreifen gewährleistet.

9. Laserresonator nach einem der Ansprüche 1 bis 8, dadurch gekennzeichnet, daß die erste Fläche der ersten Zone mit einer metallischen Abscheidung (42) versehen ist, die in einem mittleren Teil eine streifenförmige öffnung aufweist, welche seitliche Einschließungseinrichtungen der Elektronenanregung bildet.

10. Laserresonator nach einem der Ansprüche 1 bis 9, dadurch gekennzeichnet, daß der Laserresonator zwei parallele gespaltene Seitenflächen (18, 20) umfaßt, die semi-reflektierende Spiegel bilden.

11. Laserresonator nach einem der Ansprüche 1 bis 10, dadurch gekennzeichnet, daß die Heterostruktur hergestellt wird aus wenigstens einem Halbleitermatierals, ausgewählt unter:
Cd₁-ₓMnₓTe, CdₓHg₁₋ₓTe, CdₓZn₁₋ₓTe, CdₓZn_{z}Mn_{1-x-z}Te, CdₓZn₁₋ₓSe, ZnS_{y}Se_{1-y}, CdS_{y}Se_{y-1,} CdₓZn₁₋ₓS_{y}Se_{1-y}, Zn_{z}Mn_{1-z}Se, Zn_{z}Mg₁₋ₛS_{y}Se_{1-y}, GaₓAl₁₋ₓAS, GaₓAl₁₋ₓN, PbₓSn₁₋ₓTe, PbₓEu₁₋ₓSe, PbₓEU₁₋ₓSe_{y}Te_{1-y} mit 0≤x≤1, 0≤y≤1, 0≤Z≤1 und 0≤x+z≤1.

12. Herstellungsverfahren eines Laserresonators nach einem der Ansprüche 1 bis 11, dadurch gekennzeichnet, daß die Heterostruktur einer Wärmebehandlung von 150 bis 400°C unterzogen wird, um die genannten Halbleiterschichten untereinander diffundieren zu lassen.

13. Halbleiterlaser, einen Laserresonator (10) und Pumpeinrichtungen des Resonators umfassend, dadurch gekennzeichnet, daß der Resonator ein Resonator nach einem der Ansprüche 1 bis 11 ist.

14. Laser nach Anspruch 13, dadurch gekennzeichnet, daß die Pumpeinrichtungen gebildet werden durch eine Elektronenkanone (63, 64, 68).

15. Laser nach Anspruch 14, dadurch gekennzeichnet, daß die Elektronenkanone eine kalte Mikrospitzenquelle (63) zum Emittieren einer Elektronenstrahlung (63) und eine Hochspannungselektrode (68) zum Beschleunigen der Elektronen umfaßt, sowie einen Satz Elektroden (68) zur streifenförmigen Fokussierung der Elektronenstrahlung auf den Laserresonator.

16. Laser nach einem der Ansprüche 13 bis 15, dadurch gekennzeichnet, daß der Laserresonator (10) auf eine thermisch wirksame Masse (44) montiert ist, die die Temperaturkontrolle des Laserresonators gewährleistet.

17. Laser nach einem der Ansprüche 13 bis 16, dadurch gekennzeichnet, daß der Laserresonator auf eine thermisch wirksame Masse montiert ist, wobei die epitaxierten Schichten auf besagter Masse ruhen und dann ein örtlicher Abstand des Substrats von der Pufferzone hergestellt wird, um das Pumpen in Höhe der dritten Zone zu gewährleisten.

18. Laser nach Anspruch 17, dadurch gekennzeichnet, daß der Laserresonator durch Löten oder Kleben auf der thermisch wirksamen Masse befestigt wird.

19. Laser nach Anspruch 18, dadurch gekennzeichnet, daß der Laserresonator eine Oberflächenschicht (56) umfaßt, die die erste Zone (1) von der Lötung oder Klebung (46) auf der thermisch wirksamen Masse entfernt.

20. Laser nach einem der Ansprüche 17 bis 19, dadurch gekennzeichnet, daß der Laserresonator eine Ätz-Sperrschicht (54) aus Halbleitermaterial zwischen der Pufferzone und der dritten Zone umfaßt.

## Claims

1. Semiconductor heterostructure laser cavity having semiconductor layers epitaxied on a substrate, defining four zones:
a first zone (1) whose composition varies continuously from a first face (12) to a second face (22) with a gap decreasing from the first to the second face, said first zone ensuring an optical confinement and light guidance,
a second zone (2) constituting an active emission zone in contact with the second face of the first zone, having at least one quantum well (24, 26) with a gap smaller than that of the first zone,
a third zone (3) having a gap larger than that of the quantum well or wells, said third zone ensuring an optical confinement and a light guidance and its composition varies continuously from a first (30) to a second (32) face with a gap which increases from the first to the second face, the first face of the third zone being in contact with the active zone,
a fourth zone (4) constituting a buffer zone in contact with the second face of the third zone and the substrate (16), said fourth zone serving as an optical barrier for light guidance,
the forbidden energy bands of the first and third zones being at all points asymmetrical with respect to the active zone and the first and third zones defining with the active zone a structure of the asymmetrical GRINSCH type in such a way that the asymmetry ensures a centring of a guided optical mode on the active emission zone in order to obtain the maximum coupling between the emitted photons and the guided mode, one of the first and third zones also ensuring an electron excitation and the creation of electron-hole pairs with the asymmetry also ensuring an optimization of the collection and confinement of the carriers created and one of the first and third zones constituting one of the surfaces of the heterostructure.

2. Laser cavity according to claim 1, characterized in that the buffer zone (4) has a buffer layer (17) serving as an optical barrier with respect to contact of the second zone and an adapting layer (19) for contact with the substrate.

3. Laser cavity according to either of the claims 1 and 2, characterized in that the buffer zone (4) has a superlattice structure incorporating an alternation of quantum wells and quantum barriers.

4. Laser cavity according to any one of the claims 1 to 3, characterized in that the first zone (1) has a thickness greater than that of the third zone (3).

5. Laser cavity according to any one of the claims 1 to 4, characterized in that the first zone (1) has a thickness of at the most 1 µm.

6. Laser cavity according to any one of the claims 1 to 5, characterized in that the composition of the first zone at the first face is identical to the composition of the third zone at its second face and in that the composition of the first zone at its second face is identical to the composition of the third zone at its first face.

7. Laser cavity according to claim 6, characterized in that the active zone (2) has at least one quantum barrier (28) with an identical composition to that of the first and third zones respectively at their second and first faces

8. Laser cavity according to any one of the claims 1 to 7, characterized in that the heterostructure is provided with means (40, 40a) ensuring a ribbon lateral confinement of the electron excitation.

9. Laser cavity according to any one of the claims 1 to 8, characterized in that the first face of the first zone is provided with a metal deposit (42) having a ribbon-shaped opening in a median portion, constituting lateral confinement means of the electron excitation.

10. Laser cavity according to any one of the claims 1 to 9, characterized in that the laser cavity has two parallel, cleaved side faces (18, 20) constituting semireflecting mirrors.

11. Laser cavity according to any one of the claims 1 to 10, characterized in that the heterostructure is made from at least one semiconductor material chosen from among: Cd₁₋ₓ Mnₓ Te, Cdₓ Hg₁₋ₓ Te, Cdₓ Zn₁₋ₓ Te, Cdₓ Zn_{z} Mn_{1-x-z} Te, Cdₓ Zn₁₋ₓ Se, ZnS_{y} Se_{1-y}, CdS_{y} Se_{1-y}, Cdₓ Zn₁₋ₓ S_{y} Se_{1-y}, Zn_{z} Mn_{1-z} Se, Zn_{z} Mg₁₋ₛ S_{y} Se_{1-y}, Gaₓ Al₁₋ₓ As, Gaₓ Al₁₋ₓ N, Pbₓ Sn₁₋ₓ Te, Pbₓ Eu₁₋ₓ Se, Pbₓ Eu₁₋ₓ Se_{y} Te_{1-y} with 0 ≤ x ≤ 1, 0 ≤ y ≤ 1, 0≤ z ≤ 1 and 0 ≤x+z ≤1.

12. Method for the manufacture of a laser cavity according to any one of the claims 1 to 11, characterized in that the heterostructure undergoes a heat treatment at 150 to 400°C in order to inter-diffuse the said semiconductor layers.

13. Semiconductor laser having a laser cavity (10) and cavity pumping means, characterized in that the cavity is in accordance with any one of the claims 1 to 11.

14. Laser according to claim 13, characterized in that the pumping means are constituted by an electron gun (63, 64, 68).

15. Laser according to claim 14, characterized in that the electron gun has a microdot cold source (63) for emitting an electron beam (76), a high voltage anode (64) for accelerating the electrons and an electrode array (68) for the ribbon focussing of the electron beam on the laser cavity.

16. Laser according to any one of the claims 13 to 15, characterized in that the laser cavity (10) is mounted on a thermal mass (44) ensuring the temperature control of the laser cavity.

17. Laser according to any one of the claims 13 to 16, characterized in that the laser cavity is mounted on a thermal mass with the epitaxied layers resting on said mass, there then being a local freeing of the substrate and the buffer zone to ensure pumping at the third zone.

18. Laser according to claim 17, characterized in that the laser cavity is fixed by welding or bonding to the thermal mass.

19. Laser according to claim 18, characterized in that the laser cavity has a surface layer (56) moving the first zone (1) away from the weld or bond on the thermal mass.

20. Laser according to any one of the claims 17 to 19, characterized in that the laser cavity has an etching stop layer (54) made from a semiconductor material between the buffer zone and the third zone.
